(19) 

Europäisches Patentamt

European Patent Office

Office européen des brevets

(11) **EP 4 686 348 A1**

(12) # EUROPEAN PATENT APPLICATION
published in accordance with Art. 153(4) EPC

(43) Date of publication:
**28.01.2026 Bulletin 2026/05**

(21) Application number: **25746540.1**

(22) Date of filing: **12.06.2025**

(51) International Patent Classification (IPC):
***H10F 77/00*** (2025.01)

(86) International application number:
**PCT/CN2025/100738**

(87) International publication number:
**WO 2025/256602 (18.12.2025 Gazette 2025/51)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **14.06.2024 CN 202421366666 U
11.09.2024 CN 202411273475
11.09.2024 CN 202411276522**

(71) Applicants:
• **Chuzhou Aiko Solar Technology Co., Ltd.
Chuzhou, Anhui 239514 (CN)**
• **Zhuhai Fushan Aiko Solar Energy
Technology Co., Ltd.
Zhuhai, Guangdong 519000 (CN)**
• **Shenzhen Aiko Digital Energy Technology Co.,
Ltd.
Shenzhen, Guangdong 518000 (CN)**
• **Tianjin Aiko Solar Energy Technology Co., Ltd.
Tianjin 300400 (CN)**

• **Guangdong Aiko Solar Energy Technology Co.,
Ltd.
Foshan, Guangdong 528000 (CN)**
• **Zhejiang Aiko Solar Energy Technology Co., Ltd.
Jinhua, Zhejiang 322009 (CN)**
• **Shandong Aiko Solar Technology Co., Ltd
Jinan, Shandong 250000 (CN)**

(72) Inventors:
• **XU, Yehai
Jinhua, Zhejiang 322009 (CN)**
• **PENG, Qingqing
Jinhua, Zhejiang 322009 (CN)**
• **XU, Yang
Jinhua, Zhejiang 322009 (CN)**
• **ZHANG, Lingjie
Jinhua, Zhejiang 322009 (CN)**
• **HE, Daneng
Jinhua, Zhejiang 322009 (CN)**
• **CHEN, Gang
Jinhua, Zhejiang 322009 (CN)**

(74) Representative: **EP&C
P.O. Box 3241
2280 GE Rijswijk (NL)**

(54) **BACK CONTACT CELL ASSEMBLY AND SYSTEM**

(57)     The present disclosure relates to the technical field of solar cells. Disclosed are a back contact cell module and a system. The assembly includes a cell string, an insulation bar, and a bus bar; the cell string includes a first cell piece and a second cell piece, which are adjacent to each other; the insulation bar is provided on a backlight surface of the first cell piece; a second ribbon is connected to the second cell piece and the bus bar, respectively; and the insulation bar blocks the second ribbon and the first cell piece.

Fig. 1

EP 4 686 348 A1

## Description

### Cross-Reference to Related Application

The present disclosure claims priority to and benefits of Chinese Patent Application No. 202421366666.4, filed to the China National Intellectual Property Administration on June 14, 2024, as well as Chinese Patent Application No. 202411273475.8 and 202411276522.4, filed to the China National Intellectual Property Administration on September 11, 2024, the disclosures of which are hereby incorporated by reference in their entirety.

### Technical Field

The present disclosure relates to the technical field of solar cells, and in particular, to a back contact cell module and a photovoltaic system.

### Background

Electricity generated by solar cells is a sustainable clean energy source. By virtue of a photovoltaic effect of a semiconductor p-n junction, sunlight can be converted into electric energy. In the related art, a plurality of back contact cells are formed into a back contact cell module through steps such as series soldering, lamination, packaging, etc. The back contact cell module includes a bus bar for series connection; and the exposed bus bar affects the aesthetics of the solar cell, and reduces a light-receiving area of a cell piece, resulting in poor power generation efficiency.

In some products, the bus bar is mounted in a middle position of a rear side of the cell piece, and an insulation bar is provided between the bus bar and the cell piece. Although such arrangement mode can hide the bus bar, the insulation bar needs to be perforated or the bus bar needs to be replaced with insulation blocks provided intermittently, such that the bus bar can be in contact with ribbons having the same polarity on the cell piece, and be insulated from ribbons having reverse polarity on the cell piece. Such arrangement mode has high requirements for the perforation accuracy of the insulation bar and the arrangement position accuracy of the insulation blocks, causing production to be difficult, position offset easily occurs when the insulation bar is perforated or position offset occurs during lamination of the insulation blocks, and offset in a width direction easily causes short circuits.

### Summary

The present disclosure is intended to provide a back contact cell module and a photovoltaic system in response to the current state of the art.

One of the objectives of the present disclosure is to solve the problem of how to avoid the exposure of a bus bar and reduce power generation efficiency. The present disclosure can increase an effective light-receiving area of a cell module and improves assembly conversion efficiency. The bus bar is less observed from a light-receiving surface, and can even be completely hidden, thus making it more aesthetic.

Moreover, the present disclosure can effectively reduce production difficulty, and reduce the risk of short circuits, hidden cracks, and fragments of a cell piece, thereby improving reliability.

In order to achieve the above objective, the present disclosure provides the following technical solutions.

First, the present disclosure provides a back contact cell module, including a cell string, an insulation bar, and a bus bar.

The cell string includes a plurality of cell pieces in series connection, wherein the plurality of cell pieces are provided along a first direction.

The insulation bar is provided on a backlight surface of the cell piece along a second direction, where the first direction intersects the second direction.

The bus bar is provided on a side of the insulation bar facing away from the cell piece in the second direction, where the insulation bar covers a surface of a side of the bus bar close to the cell piece.

The cell string includes a first cell piece and a second cell piece, which are adjacent to each other; the insulation bar is provided on a backlight surface of the first cell piece; a second ribbon is connected to the second cell piece and the bus bar, respectively; and the insulation bar blocks the second ribbon and the first cell piece.

In some embodiments, the insulation bar covers the bus bar in the second direction, and the insulation bar covers and exceeds the bus bar in the first direction.

In some embodiments, the back contact cell module further includes a ribbon, where the ribbon includes a first ribbon and the second ribbon, the first ribbon is configured to connect adjacent cell pieces, and the second ribbon is configured to connect the cell piece and the bus bar.

In some embodiments, the second ribbon is provided on a side of the bus bar away from the insulation bar or the second ribbon is provided on a side of the bus bar close to the insulation bar.

In some embodiments, the first cell piece and the second cell piece are at least partially stacked together.

In some embodiments, when the backlight surface of the first cell piece and a light-receiving surface of the second cell piece are at least partially stacked together, the insulation bar is at least partially connected to a backlight surface of the second cell piece.

In some embodiments, the cell piece is rectangular in shape; the cell piece further includes a chamfer edge and a cutting edge; the chamfer edge and the cutting edge both are provided on two sides of the cell piece in the first direction; and the first direction is perpendicular to the second direction.

In some embodiments, in the first direction, the chamfer edge of one cell piece of two adjacent cell pieces abuts against the chamfer edge of an other cell piece of two adjacent cell piece, and the cutting edge of one cell piece of two adjacent cell pieces abuts against the cutting edge of an other cell piece of two adjacent cell piece; or in the first direction, the chamfer edge of one cell piece of two adjacent cell pieces abuts against the cutting edge of an other cell piece of two adjacent cell piece, and the cutting edge of one cell piece of two adjacent cell pieces abuts against the chamfer edge of an other cell piece of two adjacent cell piece.

In some embodiments, the chamfer edge of each of the cell pieces is stacked on the backlight surface of the side in which the cutting edge of the adjacent cell piece is located.

Second, the present disclosure provides a back contact cell module, including a cell string, a first insulation bar, a first bus bar, and a second ribbon A.

The cell string includes cell pieces serially connected to each other, where the cell pieces include a fifth cell piece and a sixth cell piece, which are provided in a first direction.

The first insulation bar is provided on an end of the sixth cell piece close to the fifth cell piece.

The first bus bar is provided on a side of the first insulation bar facing away from the sixth cell piece.

The first insulation bar and the first bus bar both extend in a second direction, and the first direction intersects the second direction.

The second ribbon A is configured to electrically connect the first bus bar and the fifth cell piece.

In the first direction, a first widened section and a second widened section, which extend outside an edge of the first bus bar, are provided on two ends of the first insulation bar; the first widened section and the second widened section are provided in sequence in a direction away from the fifth cell piece; and a width of the second widened section is less than a width of the first widened section.

In some embodiments, at least a portion of the first widened section extends outside an edge of the sixth cell piece.

In some embodiments, in the first direction, an orthographic projection of the first widened section in a thickness direction of the sixth cell piece is at least partially overlapped with an orthographic projection of the fifth cell piece in the thickness direction of the sixth cell piece.

In some embodiments, in the first direction, the width of the second widened section is $D2 \geq 1$ mm.

In some embodiments, the fifth cell piece and the sixth cell piece are provided on a same plane.

$$1 \text{ mm} < D_1 \leq l_{11} + l_{12} + l_{13}$$

In the formula, $D_1$ is the width of the first widened section in the first direction, $l_{11}$ is, in the first direction, a relative width distance between the first bus bar and an edge of the sixth cell piece close to an end of the fifth cell piece, $l_{12}$ is a space between the fifth cell piece and the sixth cell piece, $l_{13}$ is a relative width distance between an edge of the fifth cell piece close to an end of the sixth cell piece and a first solder joint, and the first solder joint is provided on the end of the fifth cell piece close to the sixth cell piece, so as to be connected to the second ribbon A.

In some embodiments, the end of the sixth cell piece close to the fifth cell piece is at least partially stacked with the fifth cell piece.

$$1 \text{ mm} < D_1 \leq l_{21} + l_{23} - l_{22}$$

In the formula, $D_1$ is the width of the first widened section in the first direction, $l_{21}$ is, in the first direction, a relative width distance between the first bus bar and the edge of the sixth cell piece close to an end of the fifth cell piece, $l_{22}$ is, in the first direction, a width of a stacking region between the fifth cell piece and the sixth cell piece, $l_{23}$ is a relative width distance between the edge of the fifth cell piece close to an end of the sixth cell piece and the first solder joint, and the first solder joint is provided on an end of the fifth cell piece close to the sixth cell piece, so as to be connected to the second ribbon A.

In some embodiments, the cell module further includes a front sheet. The cell string is provided on the front sheet, the front sheet is provided with a first edge and a second edge in the second direction, and an orthographic projection of the first insulation bar in a thickness direction of the sixth cell piece falls between the first edge and the second edge.

In some embodiments, an orthographic projection of the first bus bar in a thickness direction of the sixth cell piece falls in the sixth cell piece.

In some embodiments, the cell module includes at least one series-connected cell string group. The same series-connected cell string group includes two cell strings that are provided in the second direction and serially connected to each other; and the same series-connected cell string group extends from the sixth cell piece in one cell string to the sixth cell piece of an other cell string through a same first bus bar.

In some embodiments, a fourth cell piece is provided on an end of each cell string away from the fifth cell piece, and a third cell piece is provided on an end of the fourth cell piece close to the fifth cell piece.

The back contact cell module further includes a second insulation bar, an intermediate bus bar, and a second ribbon B.

The second insulation bar is provided on an edge of the third cell piece in one cell string and provided on an end of the third cell piece close to the fourth cell piece.

The intermediate bus bar is configured to parallelly connect two cell strings, which are adjacent to each other in the first direction. The intermediate bus bar is provided on a side of the second insulation bar facing away from the third cell piece.

The second insulation bar and the intermediate bus bar both extend in the second direction.

The second ribbon B is configured to electrically connect the intermediate bus bar, the fourth cell piece in the cell string, and the fourth cell piece in another cell string adjacent to the cell string in the first direction.

In some embodiments, in the first direction, a first protruding segment and a second protruding segment, which extend outside an edge of the intermediate bus bar, are provided on two ends of the second insulation bar; the first protruding segment and the second protruding segment are provided in sequence in a direction away from the fourth cell piece; at least a portion of the first protruding segment extends outside an edge of the third cell piece; and a width of the second protruding segment is less than a width of the first protruding segment.

Third, the present disclosure further provides a back contact cell module, including a parallel-connected cell string group, a second insulation bar, an intermediate bus bar, and a second ribbon B.

The same parallel-connected cell string group includes at least two cell strings that are provided in a first direction and parallelly connected to each other, each cell string includes cell pieces serially connected to each other, the series-connected cell pieces include a third cell piece and a fourth cell piece provided in the first direction, and the fourth cell pieces in the two parallel-connected cell strings are adjacent to each other in the first direction.

The second insulation bar is provided on an edge of the third cell piece in one cell string and provided on an end of the third cell piece close to the fourth cell piece.

The intermediate bus bar is configured to parallelly connect two cell strings, which are adjacent to each other in the first direction. The intermediate bus bar is provided on a side of the second insulation bar facing away from the third cell piece.

The second insulation bar and the intermediate bus bar both extend in the second direction.

The second ribbon B is configured to electrically connect the intermediate bus bar, the fourth cell piece in the cell string in which the intermediate bus bar is located, and the fourth cell piece in another cell string adjacent to the cell string in the first direction.

In the first direction, a first protruding segment and a second protruding segment, which extend outside an edge of the intermediate bus bar, are provided on two ends of the second insulation bar; the first protruding segment and the second protruding segment are provided in sequence in a direction away from the fourth cell piece; and a width of the second protruding segment is less than a width of the first protruding segment.

In some embodiments, at least a portion of the first protruding segment extends outside an edge of the third cell piece.

In some embodiments, in the first direction, an orthographic projection of the first protruding segment in a thickness direction of the third cell piece is at least partially overlapped with an orthographic projection of the fourth cell piece in the thickness direction of the third cell piece.

In some embodiments, in the first direction, the width of the second protruding segment is $d_2 \geq 1$ mm.

In some embodiments, the fourth cell piece and the third cell piece are provided on a same plane.

$$1 \text{ mm} < d_1 \leq l_{31} + l_{32} + l_{33}$$

In the formula, $d_1$ is the width of the first protruding segment in the first direction; $l_{31}$ is, in the cell string in which the intermediate bus bar is provided, and in the first direction, a relative width distance between the intermediate bus bar and the edge of the third cell piece close to an end of the fourth cell piece; $l_{32}$ is, in the cell string in which the intermediate bus bar is provided, a space between the fourth cell piece and the third cell piece; $l_{33}$ is, in the cell string in which the intermediate bus bar is provided, a relative width distance between the edge of the fourth cell piece close to an end of the third cell piece and a second solder joint; and the second solder joint is provided on the fourth cell piece in the cell string in which the intermediate bus bar is provided, and is provided on an end of the fourth cell piece close to the third cell piece, so as to be connected to the second ribbon B.

In some embodiments, in the cell string in which the intermediate bus bar is provided, the end of the third cell piece close to the fourth cell piece is at least partially stacked with the fourth cell piece.

$$1 \text{ mm} < d_1 \leq l_{41} + l_{43} - l_{42}$$

In the formula, $d_1$ is the width of the first protruding segment in the first direction; $l_{41}$ is, in the cell string in which the intermediate bus bar is provided, and in the first direction, a relative width distance between the intermediate bus bar and the edge of the third cell piece close to an end of the fourth cell piece; $l_{42}$ is, in the first direction, a width of a stacking region between the third cell piece and the fourth cell piece; $l_{43}$ is, in the cell string in which the intermediate bus bar is provided, a relative width distance between the edge of the fourth cell piece close to an end of the third cell piece and a second solder joint; and the second solder joint is provided on the end of the fourth cell piece close to the end of the third cell piece, so as to be connected to the second ribbon B.

In some embodiments, the cell module further includes a front sheet. The cell string is provided on the front sheet, the front sheet is provided with a first edge and a second edge in the second direction, and an orthographic projection of the second insulation bar in a thickness direction of the third cell piece falls between the first edge and the second edge.

Fourth, a back contact cell module, including a cell string, a first insulation bar, a first insulation bar, and a second ribbon A.

The cell string includes cell pieces serially connected to each other, where the cell pieces include a fifth cell piece and a sixth cell piece, which are provided in a first direction.

The first insulation bar is provided on an end of the sixth cell piece close to the fifth cell piece.

The first bus bar is provided on a side of the first insulation bar facing away from the sixth cell piece.

The first insulation bar and the first bus bar both extend in a second direction, and the first direction intersects the second direction.

The second ribbon A is configured to electrically connect the first bus bar and the fifth cell piece.

An protruding segment extending outside the first bus bar is provided on an end of the first insulation bar close to the fifth cell piece, the protruding segment extends outside the sixth cell piece, and in a thickness direction of the sixth cell piece, an orthographic projection of the protruding segment is at least partially overlapped with an orthographic projection of the fifth cell piece.

In some embodiments, the fifth cell piece and the sixth cell piece are provided on the same plane.

In the first direction, a width of a portion of the protruding segment extending outside the sixth cell piece is greater than a space between the fifth cell piece and the sixth cell piece.

In some embodiments, in the first direction, the width of the protruding segment is as follows.

$$1 \text{ mm} \le L_1 \le l_{11} + l_{12} + l_{13}$$

In the formula, $L_1$ is the width of the protruding segment in the first direction; $l_{11}$ is the space between the fifth cell piece and the sixth cell piece; $l_{12}$ is a relative width distance between an edge of the fifth cell piece close to an end of the sixth cell piece and a first solder joint; the first solder joint is configured to be connected to the second ribbon A, and is provided on the end of the fifth cell piece close to the sixth cell piece; and $l_{13}$ is a relative width distance between an edge of the first bus bar close to the end of the fifth cell piece and the edge of the sixth cell piece close to the end of the fifth cell piece.

In some embodiments, in the first direction, width of the protruding segment is as follows.

$$1 \text{ mm} \le L_1 \le l_{11} + l_{13} + 4 \text{ mm}$$

In the formula, $L_1$ is the width of the protruding segment in the first direction; $l_{11}$ is the space between the fifth cell piece and the sixth cell piece; $l_{13}$ is the relative width distance between the edge of the first bus bar close to the end of the fifth cell piece and the edge of the sixth cell piece close to the end of the fifth cell piece.

In some embodiments, the end of the sixth cell piece close to the fifth cell piece is at least partially stacked with the fifth cell piece.

In the first direction, a width of the protruding segment is greater than a width of a stacking region between the fifth cell piece and the sixth cell piece.

In some embodiments, the width of the protruding segment is as follows.

$$1 \text{ mm} \le L_2 \le l_{22} + l_{23} - l_{21}$$

In the formula, $L_2$ is the width of the protruding segment in the first direction; $l_{21}$ is the width of the stacking region between the fifth cell piece and the sixth cell piece; $l_{22}$ is a relative width distance between an edge of the fifth cell piece close to an end of the sixth cell piece and a first solder joint; the first solder joint is configured to be connected to the second ribbon A, and is provided on the end of the fifth cell piece close to the sixth cell piece; and $l_{23}$ is a relative width distance between an edge of the first bus bar close to the end of the fifth cell piece and the edge of the sixth cell piece close to the end of the fifth cell piece.

In some embodiments, the width of the protruding segment is as follows.

$$1 \text{ mm} \le L_2 \le l_{23} + 4 \text{ mm} - l_{21}$$

In the formula, $L_2$ is the width of the protruding segment in the first direction; $l_{21}$ is the width of the stacking region between the fifth cell piece and the sixth cell piece; $l_{23}$ is the relative width distance between the edge of the first bus bar close to the end of the fifth cell piece and the edge of the sixth cell piece close to the end of the fifth cell piece.

In some embodiments, the cell module includes at least one series-connected cell string group. The same series-connected cell string group includes two cell strings that are provided in the second direction and serially connected to each other; and the same series-connected cell string group extends from the sixth cell piece in one cell string to the sixth cell piece of the other cell string through the same first bus bar.

In some embodiments, a fourth cell piece is provided on an end of each cell string away from the fifth cell piece, and a third cell piece is provided on an end of the fourth cell piece close to the fifth cell piece.

The cell module includes a parallel-connected cell string group, wherein the same parallel-connected cell string group includes at least two cell strings that are provided in the first direction and parallelly connected to each other, and the fourth cell pieces in the two parallel-connected cell strings are adjacent to each other in the first direction.

The back contact cell module further includes a second insulation bar, an intermediate bus bar, and a second ribbon B.

The second insulation bar is provided on an edge of the third cell piece in one cell string and provided on an end of the third cell piece close to the fourth cell piece.

The intermediate bus bar is configured to parallelly connect two cell strings, which are adjacent to each other in the first direction. The intermediate bus bar is provided on a side of the second insulation bar facing away from the third cell piece.

The second insulation bar and the intermediate bus bar both extend in the second direction.

The second ribbon B is configured to electrically connect the intermediate bus bar, the fourth cell piece in the cell string, and the fourth cell piece in another cell string adjacent to the cell string in the first direction.

**In** some embodiments, an extended portion extending outside the intermediate bus bar is provided on an end of the second insulation bar close to the fourth cell piece, and extends outside the third cell piece; and in a thickness direction of the third cell piece, an orthographic projection of the extended portion is at least partially overlapped with an orthographic projection of the fourth cell piece in the cell string in which the extended portion is located.

Fifth, the present disclosure provides a back contact cell module, including a parallel-connected cell string group, a second insulation bar, an intermediate bus bar, and a second ribbon B.

The same parallel-connected cell string group includes at least two cell strings that are provided in a first direction and parallelly connected to each other, each cell string includes cell pieces serially connected to each other, the cell pieces include a third cell piece and a fourth cell piece provided in the first direction, and the fourth cell pieces in the two parallel-connected cell strings are adjacent to each other in the first direction.

The second insulation bar is provided on an edge of the third cell piece in one cell string and provided on an end of the third cell piece close to the fourth cell piece.

The intermediate bus bar is configured to parallelly connect two cell strings, which are adjacent to each other in the first direction. The intermediate bus bar is provided on a side of the second insulation bar facing away from the third cell piece.

The second insulation bar and the intermediate bus bar both extend in the second direction.

The second ribbon B is configured to electrically connect the intermediate bus bar, the fourth cell piece in the cell string in which the intermediate bus bar is located, and the fourth cell piece in another cell string adjacent to the cell string in the first direction.

An extended portion extending outside the intermediate bus bar is provided on an end of the second insulation bar close to the fourth cell piece, and extends outside the third cell piece; and in a thickness direction of the third cell piece, an orthographic projection of the extended portion is at least partially overlapped with an orthographic projection of the fourth cell piece in the cell string in which the extended portion is located.

In some embodiments, in the cell string in which the second insulation bar is provided, the fourth cell piece and the third cell piece are provided on the same plane.

In the first direction, a width of a portion of the extended portion extending outside the third cell piece is greater than a space between the fourth cell piece and the third cell piece.

In some embodiments, in the first direction, the width of the extended portion is as follows.

$$1 \text{ mm} \leq L_3 \leq l_{31} + l_{32} + l_{33}$$

In the formula, $L_3$ is the width of the extended portion in the first direction; $l_{31}$ is, in the cell string in which the second insulation bar is provided, a space between the fourth cell piece and the third cell piece; $l_{32}$ is, in the cell string in which the second insulation bar is provided, a relative width distance between an edge of the fourth cell piece close to an end of the third cell piece and a second solder joint; and $l_{33}$ is, in the cell string in which the second insulation bar is provided, a relative width distance between an edge of the intermediate bus bar close to the end of the fourth cell piece and the edge of the third cell piece close to the end of the fourth cell piece.

In some embodiments, in the first direction, the width of the extended portion is as follows.

$$1 \text{ mm} \leq L_3 \leq l_{31} + l_{33} + 4 \text{ mm}$$

In the formula, $L_3$ is the width of the extended portion in the first direction; $l_{31}$ is, in the cell string in which the second insulation bar is provided, a space between the fourth cell piece and the third cell piece; and $l_{33}$ is, in the cell string in which the second insulation bar is provided, the relative width distance between the edge of the intermediate bus bar close to the end of the fourth cell piece and the edge of the third cell piece close to the end of the fourth cell piece.

In some embodiments, in the cell string in which the second insulation bar is provided, the end of the third cell piece close to the fourth cell piece is at least partially stacked with the fourth cell piece.

In the first direction, a width of the extended portion is greater than a width of a stacking region between the third cell piece and the fourth cell piece.

In some embodiments, in the first direction, the width of the extended portion is as follows.

$$1 \text{ mm} \leq L_4 \leq l_{42} + l_{43} - l_{41}$$

In the formula, $L_4$ is the width of the extended portion in the first direction; $l_{41}$ is the width of a stacking region between the third cell piece and the fourth cell piece; $l_{42}$ is, in the cell string in which the second insulation bar is provided, a relative width distance between an edge of the fourth cell piece close to an end of the third cell piece and a second solder joint; and $l_{43}$ is, in the cell string in which the second insulation bar is provided, a relative width distance between an edge of the intermediate bus bar close to the end of the fourth cell piece and the edge of the third cell piece close to the end of the fourth cell piece.

In some embodiments, in the first direction, the width of the extended portion is as follows.

$$1 \text{ mm} \leq L_4 \leq l_{43} - l_{41} + 4 \text{ mm}$$

In the formula, $L_4$ is the width of the extended portion in the first direction; $l_{41}$ is the width of a stacking region between the third cell piece and the fourth cell piece; $l_{42}$ is, in the cell string in which the second insulation bar is provided, a relative width distance between an edge of the fourth cell piece close to an end of the third cell piece and a second solder joint; and $l_{43}$ is, in the cell string in which the second insulation bar is provided, a relative width distance between an edge of the intermediate bus bar close to the end of the fourth cell piece and the edge of the third cell piece close to the end of the fourth cell piece.

Sixth, the present disclosure further provides a photovoltaic system, including the above back contact cell module.

The beneficial effects of the present disclosure are as follows.

1) In the present disclosure, the bus bar is hidden on backlight surfaces of the plurality of cell pieces, and cannot be observed from light-receiving surfaces, such that a front side of the back contact cell module has a uniform and attractive color. Moreover, the insulation bar can be provided between the bus bar and the cell piece, thereby avoiding the problem of short circuits. Then, compared to a bus bar provided in an intermediate position of a rear side of the cell piece, the bus bar of the present disclosure is provided on the end of the first cell piece close to the second cell piece, and the second ribbon is provided on the second cell piece, the second ribbon can be fully attached to and soldered with an effective soldering position of the second cell piece, such that the insufficient soldering between the second ribbon and the second cell piece caused by the mounting of the bus bar is prevented from affecting collection of currents. Moreover, the second ribbon can be directly connected to the bus bar after being soldered with the second cell piece, without perforating the insulation bar or replacing the insulation bar with insulation blocks provided intermittently. During assembly, the entire insulation bar only needs to be placed on the end of the first cell piece close to the second cell piece, such that production accuracy requirements and production difficulty are effectively reduced, and position offset occurring when the insulation bar is perforated or position offset occurring during lamination of the insulation blocks can be avoided, thereby improving a product yield.

2) Through the end bus bar in-built structure of the present disclosure, in an aspect, an effective light-receiving area of the cell module can be increased, and assembly conversion efficiency is improved. The bus bar is less observed from a light-receiving surface, and can even be completely hidden, thus making the entire cell module more aesthetic. In another aspect, it can ensure that the second ribbon A can be fully attached to and soldered with an effective soldering position of the fifth cell piece, such that the insufficient soldering between the second ribbon A and the fifth cell piece caused by the mounting of the first bus bar is prevented from affecting collection of currents. During assembly, the entire first insulation bar only needs to be placed on the end of the sixth cell piece close to the fifth cell piece. Moreover, through the arrangement of the first widened section and the second widened section, during preparation, the first insulation bar can be allowed to offset to a certain extent in the width direction relative to the first bus bar, as well as relative to two cell pieces, thereby effectively reducing production accuracy requirements and short-circuit risks, and ensuring that the cell module has a high bifaciality. Furthermore, the end bus bar in-built structure of the present disclosure can be suitable for a back contact cell module with a Busbar and a back contact cell module without a Busbar, and thus is stronger in universality. The end bus bar in-built structure has smaller stress during lamination, such that the risks of hidden cracks and fragments of the cell piece can be reduced, thereby achieving the good reliability of the back contact cell module.

3) Through the intermediate bus bar in-built structure of the present disclosure, in an aspect, an effective light-receiving area of the cell module can be increased, and assembly conversion efficiency is improved. The bus bar is less observed from a light-receiving surface, and can even be completely hidden, thus making the entire cell module more aesthetic. In another aspect, it can ensure that the second ribbon B can be fully attached to and soldered with an effective soldering position of the fourth cell piece, such that the insufficient soldering between the second ribbon B and the fourth cell piece caused by the mounting of the first bus bar is prevented from affecting collection of currents. During assembly, the entire second insulation bar only needs to be placed on the end of the third cell piece close to the fourth cell piece. Moreover, through the arrangement of the first extended portion and the second extended portion, during preparation, the second insulation bar can be allowed to offset to a certain extent in the width direction relative to the intermediate bus bar, as well as relative to two cell pieces, thereby effectively reducing production accuracy requirements and short-circuit risks, and ensuring that the cell module has a high bifaciality. Furthermore, the intermediate bus bar in-built structure of the present disclosure can be suitable for the back contact cell module with the Busbar and the back contact cell module without the Busbar, and thus is stronger in universality. The intermediate bus bar in-built structure has smaller stress during lamination, such that the risks of hidden cracks and fragments of the cell piece can be reduced, thereby achieving the good reliability of the back contact cell module.

4) Through the end bus bar in-built structure of the present disclosure, in an aspect, an effective light-receiving area of the cell module can be increased, and assembly conversion efficiency is improved. The bus bar is less observed from a light-receiving surface, and can even be completely hidden, thus making the entire cell module more aesthetic. In another aspect, it can ensure that the second ribbon A can be fully attached to and soldered with an effective soldering position of the fifth cell piece, such that the insufficient soldering between the second ribbon A and the fifth cell piece caused by the arrangement of the first bus bar is prevented from affecting collection of currents. During assembly, the entire first insulation bar only needs to be placed on the end of the sixth cell piece close to the fifth cell piece. Moreover, through the arrangement of the extended portion, during preparation, the first insulation bar can be allowed to offset to a certain extent in the width direction relative to the first bus bar, as well as relative to two cell pieces, such that production accuracy requirements and production difficulty are effectively reduced, and the risks of short circuits can be effectively reduced. Furthermore, the end bus bar in-built structure of the present disclosure can be suitable for a back contact cell module with a Busbar and a back contact cell module without a Busbar, and thus is stronger in universality. The end bus bar in-built structure has smaller stress during lamination, such that the risks of hidden cracks and fragments of the cell piece can be reduced, thereby achieving the good reliability of the back contact cell module.

5) Through the intermediate bus bar in-built structure of the present disclosure, in an aspect, an effective light-receiving area of the cell module can be increased, and assembly conversion efficiency is improved. The bus bar is less observed from a light-receiving surface, and can even be completely hidden, thus making the entire cell module more aesthetic. In another aspect, it can ensure that the second ribbon B can be fully attached to and soldered with an effective soldering position of the fourth cell piece, such that the insufficient soldering between the second ribbon B and the fourth cell piece caused by the mounting of the intermediate bus bar is prevented from affecting collection of currents. During assembly, the entire second insulation bar only needs to be placed on the end of the third cell piece close to the fourth cell piece. Moreover, through the arrangement of the extended portion, during preparation, the second insulation bar can be allowed to offset to a certain extent in the width direction relative to the intermediate bus bar, as well as relative to two cell pieces, such that production accuracy requirements and production difficulty are effectively reduced, and the risks of short circuits can be effectively reduced. Furthermore, the intermediate bus bar in-built structure of the present disclosure can be suitable for the back contact cell module with the Busbar and the back contact cell module without the Busbar, and thus is stronger in universality. The intermediate bus bar in-built structure has smaller stress during lamination, such that the risks of hidden cracks and fragments of the cell piece can be reduced, thereby achieving the good reliability of the back contact cell module.

**Brief Description of the Drawings**

Fig. 1 is a schematic structural diagram of a back contact cell module according to embodiments of the present disclosure.

Fig. 2 is a schematic diagram of a cross-sectional structure of a back contact cell module according to embodiments of the present disclosure.

Fig. 3 is a schematic diagram of another cross-sectional structure of a back contact cell module according to embodiments of the present disclosure.

Fig. 4 is another schematic structural diagram of a back contact cell module according to embodiments of the present disclosure.

Fig. 5 is another schematic structural diagram of a back contact cell module according to embodiments of the present disclosure.

Fig. 6 is a schematic structural diagram of a photovoltaic system according to embodiments of the present disclosure.

Fig. 7 is a schematic structural diagram of a series-connected cell string group according to embodiments of the present disclosure.

Fig. 8 is a schematic diagram of a cross-sectional structure of an end bus bar in-built structure according to embodiments of the present disclosure.

Fig. 9 is a schematic structural diagram of a cell string according to embodiments of the present disclosure.

Fig. 10 is another schematic structural diagram of a back contact cell module according to embodiments of the present disclosure.

Fig. 11 is a schematic structural diagram of a parallel-connected cell string group (adjacent cell pieces being on the same plane) according to embodiments of the present disclosure.

Fig. 12 is a schematic diagram of another cross-sectional structure of an end bus bar in-built structure according to embodiments of the present disclosure.

Fig. 13 is a schematic diagram of another cross-sectional structure of an end bus bar in-built structure according to embodiments of the present disclosure.

Fig. 14 is a schematic structural diagram of a series-connected cell string group (adjacent cell pieces being stacked) according to embodiments of the present disclosure.

Fig. 15 is a schematic diagram of another cross-sectional structure of an end bus bar in-built structure according to embodiments of the present disclosure.

Fig. 16 is a schematic structural diagram of a parallel-connected cell string group (adjacent cell pieces being stacked) according to embodiments of the present disclosure.

Fig. 17 is a schematic diagram of a cross-sectional structure of an intermediate bus bar in-built structure according to embodiments of the present disclosure.

Fig. 18 is a schematic diagram of another cross-sectional structure of an intermediate bus bar in-built structure according to embodiments of the present disclosure.

Fig. 19 is a schematic diagram of another cross-sectional structure of an end bus bar in-built structure according to embodiments of the present disclosure.

Fig. 20 is a schematic diagram of another cross-sectional structure of an end bus bar in-built structure according to embodiments of the present disclosure.

Fig. 21 is a schematic diagram of another cross-sectional structure of an end bus bar in-built structure according to embodiments of the present disclosure.

Fig. 22 is a schematic diagram of another cross-sectional structure of an end bus bar in-built structure according to embodiments of the present disclosure.

Fig. 23 is a schematic diagram of another cross-sectional structure of an intermediate bus bar in-built structure according to embodiments of the present disclosure.

Fig. 24 is a schematic diagram of another cross-sectional structure of an intermediate bus bar in-built structure according to embodiments of the present disclosure.

**Detailed Description of the Embodiments**

To make the objectives, technical solutions and advantages of the present disclosure clearer, the present disclosure is further described in detail with reference to the drawings and embodiments. Examples of the embodiments are shown in the accompanying drawings, where the same or similar reference numerals throughout the present disclosure represent the same or similar elements or the elements having the same or similar functions. The embodiments described below with reference to the accompanying drawings are exemplary, and are only intended to be illustrative of the present disclosure and cannot be construed as limiting the present disclosure. In addition, it should be understood that specific embodiments described herein are merely intended to explain the present disclosure instead of limiting the present disclosure.

In the description of the present disclosure, it is understood that orientation or position relationships indicted by terms such as "length", "width", "up", "below", "left", "right", "horizontal", "top", "bottom", and the like are based on orientation or position relationships shown in the drawings, are merely to facilitate the description of the present disclosure and simplify the description, instead of indicating or implying that the indicated device or element must have particular orientations or be constructed and operated in particular orientations, and cannot be construed as limiting the present disclosure.

In the descriptions of the present disclosure, the terms "first", "second", "third", "fourth", etc. are used for descriptive purposes only and are not to be construed as indicating or implying relative importance or implicitly specifying the number of technical features indicated. Thus, features defined by "first", "second", "third", and "fourth" can explicitly or implicitly comprise one or more of the features. In the description of the present disclosure, the meaning of "a plurality of" or "several" is two or more, unless explicitly and specifically defined otherwise.

In the description of the present disclosure, it is to be noted that, unless otherwise clearly specified and limited, the terms "mounted", "connected" and "connect" should be interpreted broadly. For example, the term "connect" can be fixed connection, detachable connection or integral construction. As an alternative, the term "connect" can be mechanical connection, or electrical connection, or mutual communication. As an alternative, the term "connect" can be direct connection, or indirect connection through a medium, or communication in two elements or the interaction between two components. For those of ordinary skill in the art, specific meanings of the foregoing terms in the present disclosure can be understood based on specific situations.

In the present disclosure, unless otherwise explicitly specified and defined, a first feature being "over" or "below" a second feature can mean that the first feature and the second feature are in direct contact, or the first feature and the second feature are not in direct contact but are in contact through another feature therebetween. Moreover, the first feature being "over", "above", and "on" the second feature includes that the first feature is directly above or obliquely above the second feature, or merely means that the first feature has a larger horizontal height than the second feature. The first feature being "beneath", "under" and "below" the second feature including the first feature being right under or at an inclined lower portion of the second feature, or simply indicating that the horizontal height of the first feature is less than that of the second feature.

The following disclosure provides many different embodiments or examples for achieving different structures of the present disclosure. In order to simplify the present disclosure of the present disclosure, components and settings of specific examples are described below. Certainly, they are merely examples, and are not intended to limit the present disclosure. In addition, the present disclosure can repeat reference numerals and/or reference letters in different examples. The repetition is for the purpose of simplification and clarity, but does not indicate a relationship between the various embodiments and/or settings discussed. In addition, the present disclosure provides examples of various specific processes and materials, but those of ordinary skill in the art can be aware of the application of other processes and/or usage scenarios of other materials.

In the related art, the exposed bus bar affects the aesthetics of the solar cell, and reduces a light-receiving area of a cell piece, resulting in poor power generation efficiency. In the present disclosure, the bus bar is hidden on backlight surfaces of the plurality of cell pieces, and cannot be observed from light-receiving surfaces, such that a front side of the back contact cell module has a uniform and attractive color. Moreover, the insulation bar can be provided between the bus bar and the cell piece, thereby avoiding the problem of short circuits.

Then, compared to a bus bar provided in an intermediate position of a rear side of the cell piece, the bus bar of the present disclosure is provided on the end of the first cell piece close to the second cell piece, the second ribbon is provided on the second cell piece, and the second ribbon can be fully attached to and soldered with an effective soldering position of the second cell piece, such that the insufficient soldering between the second ribbon and the second cell piece caused by the mounting of the bus bar is prevented from affecting collection of currents. Moreover, the second ribbon can be directly connected to the bus bar after being soldered with the second cell piece, without perforating the insulation bar or replacing the insulation bar with insulation blocks provided intermittently. During assembly, the entire insulation bar only needs to be placed on the end of the first cell piece close to the second cell piece, such that production accuracy requirements and production difficulty are effectively reduced, and position offset occurring when the insulation bar is perforated or position offset occurring during lamination of the insulation blocks can be avoided, thereby improving a product yield.

The present disclosure is further described below with reference to the drawings and embodiments.

Embodiment I

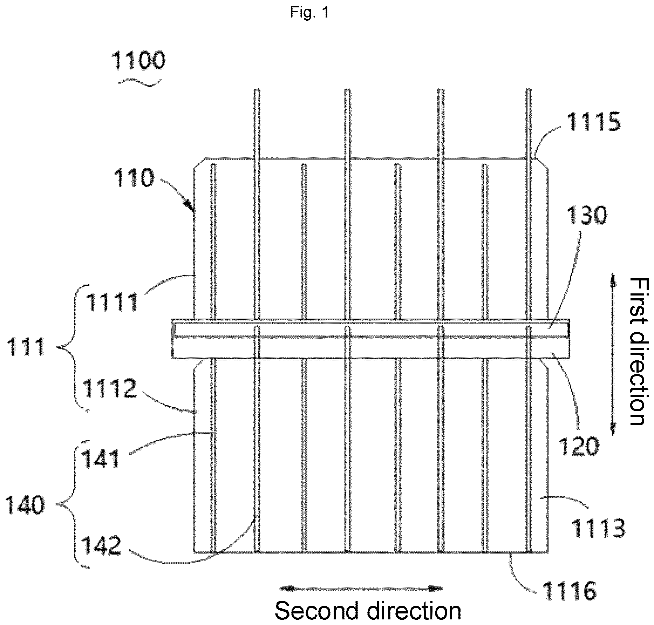

Referring to Fig. 1, Fig. 2, and Fig. 3, a back contact cell module 1100 provided in the present disclosure includes a cell string 110, an insulation bar 120, and a bus bar 130. The cell string 110 includes a plurality of cell pieces 111 in series connection, and the plurality of cell pieces 111 are provided along a first direction; the insulation bar 120 is provided on a backlight surface 1113 of the cell piece 111 along a second direction; the first direction intersects the second direction; the bus bar 130 is provided on a side of the insulation bar 120 facing away from the cell piece 111 along the second direction; and the insulation bar 120 covers a surface of a side of the bus bar 130 close to the cell piece 111.

The cell string 110 includes a first cell piece 1111 and a second cell piece 1112, which are adjacent to each other; the insulation bar 120 is provided on a backlight surface 1113 of the first cell piece 1111; a second ribbon 142 is connected to the second cell piece 1112 and the bus bar 130, respectively; and the insulation bar 120 blocks the second ribbon 142 and the first cell piece 1111.

In this embodiment, the insulation bar 120 and the bus bar 130 both are provided along the second direction. That the insulation bar 120 covers the bus bar 130 means that, observing from the backlight surface 1113 of the cell piece 111, a projection of the bus bar 130 is completely located inside the insulation bar 120, or observing from a light-receiving surface 1114 of the cell piece 111, the insulation bar 120 can completely cover the bus bar 130, so as to prevent the bus bar 130 from exposing. Moreover, the bus bar 130 and the insulation bar 120 can be provided on the backlight surface 1113 of the cell piece 111 to avoid affecting the light-receiving surface 1114 of the cell piece 111, such that the light-receiving surface 1114 of the cell piece 111 has a larger area, and power generation efficiency is higher.

In some embodiment, the first cell piece 1111 and the second cell piece 1112 have same specifications; in some embodiments, the first cell piece 1111 and the second cell piece 1112 have different specifications. A specific relationship between the first cell piece 1111 and the second cell piece 1112 is not limited herein.

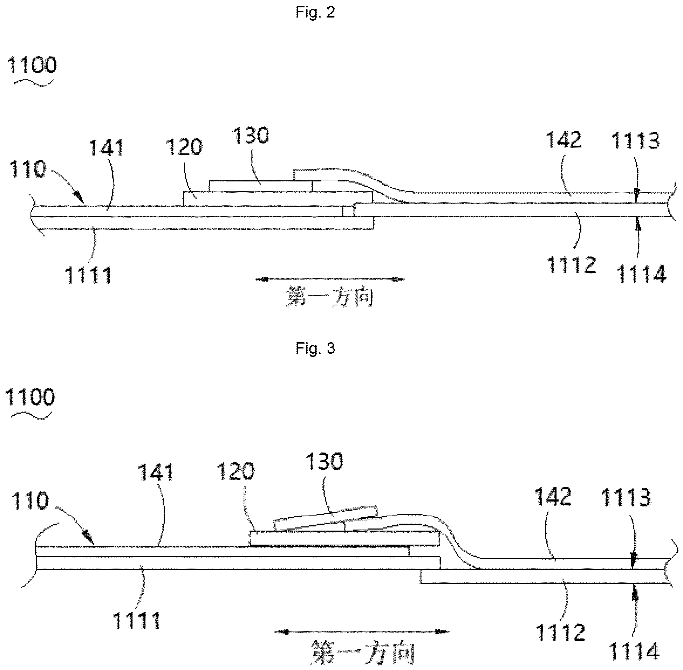

It can be understood that, "first" and "second" in the first cell piece 1111 and the second cell piece 1112 are relative concepts, meaning that two back contact cells are different. For example, in examples of Fig. 2 and Fig. 3, the back contact cell labeled on a left side is the first cell piece 1111, and the back contact cell on a right side is the second cell piece 1112.

The bus bar 130 is provided on the first cell piece 1111, and the bus bar 130 is separated from the first cell piece 1111 through the insulation bar 120. In an aspect, a space for placing the bus bar 130 does not need to be reserved in an edge of the cell module, the cell module can reserve more spaces to mount the cell pieces 111, such that the effective light-receiving area of the cell module is larger, and assembly conversion efficiency is higher. In another aspect, observing from the light-receiving surface of the cell piece 111, the insulation bar 120 can cover the bus bar 130 to prevent the bus bar 130 from exposing, thereby making the entire cell module more aesthetic. Moreover, the insulation bar 120 can be provided between the bus bar 130 and the cell piece to avoid the problem of short circuits.

Furthermore, compared to a bus bar provided in an intermediate position of a rear side of the cell piece, the bus bar 130 of the present disclosure is provided on the end of the first cell piece 1111 close to the second cell piece 1112, the second ribbon 142 is provided on the second cell piece 1112, and the second ribbon 142 can be fully attached to and soldered with an effective soldering position of the second cell piece 1112, such that the insufficient soldering between the second ribbon 142 and the second cell piece 1112 caused by the mounting of the bus bar 130 is prevented from affecting collection of currents. Moreover, the second ribbon 142 can be directly connected to the bus bar 130 after being soldered with the second cell piece 1112, without perforating the insulation bar 120 or replacing the insulation bar with insulation blocks provided intermittently. During assembly, the entire insulation bar 120 only needs to be placed on the end of the first cell piece 1111 close to the second cell piece 1112, such that production accuracy requirements and production difficulty are effectively reduced, and position offset occurring when the insulation bar 120 is perforated or position offset occurring during lamination of the insulation blocks can be avoided, thereby improving a product yield.

The insulation bar 120 in this embodiment is in a long-strip shape similar to the shape of the bus bar 130. Compared to conventional insulation components that need to be manufactured by slotting, interval distribution, punching, etc., the insulation bar 120 in this embodiment is simpler in process, and a manufacturing time can be saved. The long-strip-shaped insulation bar 120 also has the characteristics of being simpler in placement operation, low in requirement for device refinement, and higher in production yield. In this way, the comprehensive device and production manufacturing costs of the entire back contact cell module 1100 can be the lowest, and the reliability of the assembly can be better.

Optionally, in this embodiment of the present disclosure, the bus bar 130 can be an intermediate bus bar, which is located in an intermediate position of the cell string 110. The bus bar 130 can also be an end bus bar, which is located on an end of the cell string 110. The specific position and specific form of the bus bar 130 are not limited herein, so as to meet various requirements.

In this embodiment, the plurality of back contact cells in the back contact cell module 1100 can be sequentially connected in series together to form a cell string 110, so as to realize series convergence output of currents, for example, the serial connection of cell pieces 111 can be implemented by disposing a ribbon 140 (the bus bar 130 or an interconnection bar), a conductive backsheet, etc.

It can be understood that, in this embodiment, the back contact cell module 1100 can further include a frame, a backsheet photovoltaic glass, and an adhesive film. The adhesive film can be filled between the front side and back side of the back contact cell and the photovoltaic glass, or the adjacent cell pieces 111, etc. As a filler, the adhesive film can be a transparent colloid with good transmittance performance and aging resistance. For example, the adhesive film can use an EVA adhesive film or a POE adhesive film, which can be specifically selected according to actual situations, and is not limited herein.

The photovoltaic glass can be covered on the adhesive film of the front side of the back contact cell. The photovoltaic glass can be ultra-clear glass, which has high transmittance, high transparency, and excellent physical, mechanical, and optical properties. For example, the transmittance of the ultra-clear glass can reach over 92%, and the ultra-clear glass can protect the back contact cell without affecting the efficiency of the back contact cell as much as possible. Furthermore, the adhesive film can bond the photovoltaic glass and the back contact cell together, and the presence of the adhesive film can perform sealed insulation and protection against water and moisture on the back contact cell.

The backsheet can be attached to the adhesive film on the back side of the back contact cell. The backsheet can protect and support the back contact cell, and has reliable insulation, water resistance, and aging resistance. The backsheet can have various options, and usually can be tempered glass, organic glass, an aluminum alloy TPT composite adhesive film, etc., which can specifically be designed according to specific situations, and is not limited herein. An integral body consisting of the backsheet, the back contact cell, the adhesive film, and the photovoltaic glass can be provided on the frame. The frame, as a main external support structure of the entire back contact cell module 1100, can perform stable support and mounting on the back contact cell module 1100, for example, the back contact cell module 1100 can be mounted, through the frame, in a position required to be mounted.

In an example, when the bus bar 130 is the end bus bar, the bus bar 130, with the ribbon 140 soldered with the bus bar 130, needs to extend to the cell piece 111 at a penultimate row, and the insulation bar 120 and the bus bar 130 both are placed in a position of the cell piece 111 at the penultimate row close to the cell piece 111 at the last row. A width of the insulation bar 120 is greater than a width of the bus bar 130. An edge of the insulation bar 120 exceeds a stacking gap, and cannot cover an effective soldering position of the cell piece 111 at the last row.

In another example, when the bus bar 130 is the intermediate bus bar, the bus bar, with the ribbon 140 soldered with the bus bar 130, needs to extend to the cell piece 111 at a penultimate row of a power generation module, and the insulation bar 120 and the bus bar 130 both are placed in a position of the cell piece 111 at the penultimate row close to the cell piece 111 at the last row. A width of the insulation bar 120 is greater than a width of the bus bar 130. An edge of the insulation bar 120 exceeds a stacking gap, and cannot cover an effective soldering position of the cell piece 111 at the last row.

It can be understood that, in the cell string 110, the cell string 110 can include two cell pieces 111 connected in series, three cell pieces 111 connected in series, or other higher number of cell pieces 111. The number of the cell pieces 111 required to be connected in series can be determined according to actual use situations.

In this embodiment of the present disclosure, the sizes and types of the bus bar 130 and the insulation bar 120 are also not limited, as long as the insulation bar 120 covers the bus bar 130, so as to meet different requirements.

Embodiment II

Referring to Fig. 1, in some optional embodiments, the insulation bar 120 covers the bus bar 130 in the second direction, and the insulation bar 120 covers and exceeds the bus bar 130 in the first direction.

Therefore, the first direction and the second direction can determine a plane in which the backlight surface 1113 of the cell piece 111 is located, such that when the insulation bar 120 and the bus bar 130 are attached to the backlight surface 1113 of the cell piece 111, the insulation bar 120 can isolate the cell piece 111 to which the bus bar 130 and the insulation bar 120 are attached, so as to avoid a short circuit between the bus bar and the insulation bar.

Embodiment III

Referring to Fig. 1, Fig. 2, and Fig. 3, in some optional embodiments, the back contact cell module 1100 further includes a ribbon 140, wherein the ribbon 140 includes a first ribbon 141 and the second ribbon 142, the first ribbon 141 is configured to connect adjacent cell pieces 111, and the second ribbon 142 is configured to connect the cell piece 111 and the bus bar 130.

In this embodiment of the present disclosure, the ribbon 140 can be configured to connect adjacent two cell pieces 111, or can also be configured to connect the adjacent cell pieces 111 and the bus bar 130. That is to say, the ribbon 140 configured to connect the two adjacent cell pieces 111 is the first ribbon 141, and the ribbon 140 configured to connect the cell piece 111 and the bus bar 130 is the second ribbon 142. The first ribbon 141 is configured to electrically connect the adjacent cell pieces 111, and the first ribbon 141 is configured to electrically connect the adjacent cell pieces 111 and the bus bar 130.

Specifically, the ribbon 140 can include a copper core and a tin layer covering the copper core. The tin layer can cover the entire surface or part of the surface of the copper core. For example, the tin layer can cover the entire surface of the copper core facing toward the cell piece 111 and the entire surface facing away from the cell piece 111, without covering the side of the copper core. For another example, the tin layer covers the entire surface of the copper core.

Optionally, in this embodiment of the present disclosure, a specific type of the tin layer is not limited to meet various requirements. For example, the tin layer can be a tin elemental layer, or can also be a tin alloy layer. The tin alloy layer includes, but is not limited to, at least one of a SnPb layer, a SnBi layer, or a SnAg layer.

Furthermore, in this embodiment of the present disclosure, a size and type of the ribbon 140 are not limited, so as to meet different requirements.

Embodiment IV

Referring to Fig. 2 and Fig. 3, in some optional embodiments, the second ribbon 142 is provided on a side of the bus bar 130 away from the insulation bar 120 or the second ribbon 142 is provided on a side of the bus bar 130 close to the insulation bar 120.

In an implementation, the second ribbon 142 is provided on the side of the bus bar 130 away from the insulation bar 120. In this way, it is simpler to solder the second ribbon 142, and the end of the second ribbon 142 can be directly soldered on an exposed surface of the bus bar 130.

In another implementation, the second ribbon 142 is provided on the side of the bus bar 130 close to the insulation bar 120. In this case, the end of the second ribbon 142 can be clamped between the bus bar 130 and the insulation bar 120, such that the bus bar 130 can be connected to the second ribbon 142 more stably. Furthermore, the second ribbon 142 is provided on the side of the bus bar 130 close to the insulation bar 120. That is to say, the end of the second ribbon 142 is provided between the bus bar 130 and the insulation bar 120. In this way, the second ribbon 142 can have a smaller height difference with the cell piece 111, and have a better soldering effect with the cell piece 111.

Embodiment V

Referring to Fig. 1, Fig. 2, and Fig. 3, in some optional embodiments, the first cell piece 1111 and the second cell piece 1112 are at least partially stacked together.

Therefore, the back contact cell module 1100 can have a larger light-receiving surface 1114, such that components such as the ribbon 140, bus bar 130, etc. are prevented from being exposed from a gap between the first cell piece 1111 and the second cell piece 1112.

In an implementation of the present disclosure, specific positions of the first cell piece 1111 and the second cell piece 1112 are not limited, so as to meet different requirements. In an embodiment, edges of the first cell piece 1111 and the second cell piece 1112 are at least partially stacked together. In another embodiment, the second cell piece 1112 and the first cell piece 1111 can be provided at intervals. A space between the second cell piece 1112 and the first cell piece 1111 is within an appropriate range, such that small operation spaces and large soldering difficulty caused by a too small space can be avoided, and the waste of assembly spaces and the increasing of costs caused by a too large space can also be avoided.

Embodiment VI

Referring to Fig. 1 and Fig. 2, in some optional embodiments, when the backlight surface 1113 of the first cell piece 1111 and a light-receiving surface 1114 of the second cell piece 1112 are at least partially stacked together, the insulation bar 120 is at least partially connected to a backlight surface 1113 of the second cell piece 1112.

In this embodiment, the backlight surface 1113 of the first cell piece 1111 is in lap joint with the light-receiving surface 1114 of the second cell piece 1112, such that there is no gap between the first cell piece 1111 and the second cell piece 1112. The insulation bar 120 is provided on the backlight surface 1113 of the first cell piece 1111, and the edge of the insulation bar 120 close to the second cell piece 1112 is partially attached to the backlight surface 1113 of the second cell piece 1112. In this case, the ribbon 140 located on the backlight surface 1113 of the second cell piece 1112 can be blocked by the insulation bar 120, such that the ribbon 140 can be stably connected to the bus bar 130, thereby avoiding a short circuit between the first cell piece 1111 and the ribbon 140 or the bus bar 130.

In other embodiments, the light-receiving surface 1114 of the first cell piece 1111 and the backlight surface 1113 of the second cell piece 1112 can also be at least partially stacked, which are not specifically limited herein.

Embodiment VII

Referring to Fig. 1, Fig. 4, and Fig. 5, in some optional embodiments, the cell piece 111 is rectangular in shape; the cell piece 111 further includes a chamfer edge 1115 and a cutting edge 1116; the chamfer edge 1115 and the cutting edge 1116 both are provided on two sides of the cell piece 111 in the first direction; and the first direction is perpendicular to the second direction.

The insulation bar 120 and the bus bar 130 both can be rectangular in shape. In this case, the first direction and the second direction can be vertical directions, such that the bus bar 130, which is a small rectangle, is located inside the insulation bar 120, which is a large rectangle. The cell piece 111 can include the chamfer edge 1115 and the cutting edge 1116; extending directions of the chamfer edge 1115 and the cutting edge 1116 both are the second directions; and the chamfer edge 1115 is an edge, of which two ends are provided with chamfers.

In an implementation of the present disclosure, the positions of the chamfer edge 1115 and the cutting edge 1116 are not limited to meet different requirements. In an embodiment, the cell piece 111 can be distributed vertically. That is to say, the first direction is a vertical direction. In this case, the cell piece 111 can be distributed in the form of the chamfer edge 1115 on the top and the cutting edge 1116 on the bottom; or the cell piece 111 can be distributed in the form of the cutting edge 1116 on the top and the chamfer edge 1115 on the bottom.

In this embodiment, a preparation process of the cell piece 111 is not limited, so as to meet different requirements. For example, the cell piece 111 can be formed by cutting a large rectangular cell piece 111. Chamfers can be formed at four corners before cutting, and then cutting is performed in an intermediate position, so a to form two molded cell pieces 111. The cell piece 111 has the chamfer edge 1115 and the cutting edge 1116, which are parallel to each other.

Embodiment VIII

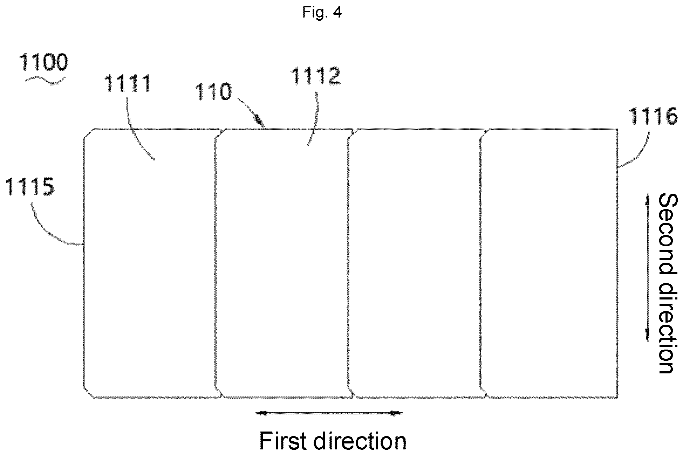

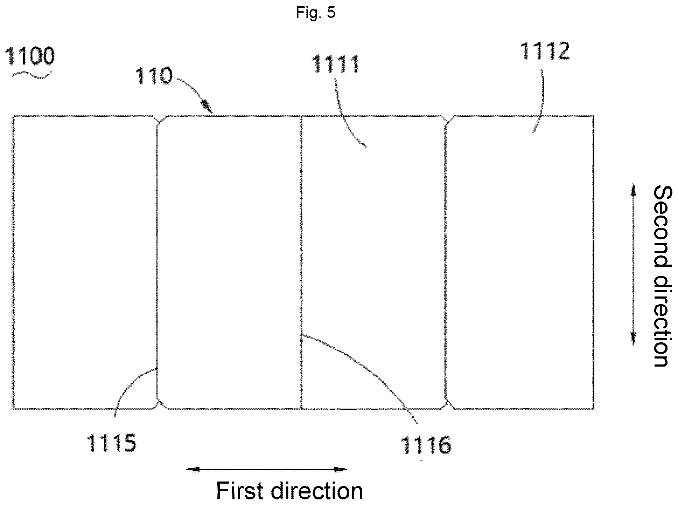

Referring to Fig. 4 and Fig. 5, in some optional embodiments, in the first direction, the chamfer edge 1115 of one cell piece 111 of two adjacent cell pieces 111 abuts against the chamfer edge 1115 of an other cell piece of two adjacent cell pieces 111, and the cutting edge 1116 of one cell piece 111 of two adjacent cell pieces 111 abuts against the cutting edge 1116 of an other cell piece of two adjacent cell pieces 111.

Alternatively, in the first direction, the chamfer edge 1115 of one cell piece111 of two adjacent cell pieces 111 abuts against the cutting edge 1116 of an other cell piece of two adjacent cell pieces 111, and the cutting edge 1116 of one cell piece111 of two adjacent cell pieces 111 abuts against the chamfer edge 1115 of an other cell piece of two adjacent cell pieces 111.

In an implementation, the adjacent cell pieces 111 are provided symmetrically. In a direction from left to right, in the first one among the cell pieces 111, the chamfer edge 1115 is placed on a left side, and the cutting edge 1116 is placed on a right side; in the first one among the cell pieces 111, the cutting edge 1116 is placed on the left side, and the chamfer edge 1115 is placed on the right side; the third one among the cell pieces 111, the chamfer edge 1115 is placed on the left side, and the cutting edge 1116 is placed on the right side, and so on. In this way, the cell piece 111 is positioned more easily, and the positions of the ribbon 140, bus bar 130, and insulation bar 120 can be determined according to a placement direction of the cell piece 111.

In another implementation, the placement modes of the cell pieces 111 are the same. In the direction from left to right, the chamfer edges 1115 are all placed on the left side, and the cutting edges 1116 are all placed on the right side. The plurality of cell pieces 111 are in lap joint in sequence. In this case, the cutting edge 1116 of the cell piece 111 on the left side abuts against the chamfer edge 1115 of the cell piece 111 on the right side. Definitely, in this implementation, left and right are relative concepts, and therefore, it can also be that the chamfer edge 1115 is placed on the right side, and the cutting edge 1116 is placed on the left side. In this way, the cell piece 111 is mounted more simply.

Embodiment IX

In an implementation, as shown in Fig. 4, the chamfer edge 1115 of the cell piece 111 is stacked on the backlight surface of the side on which the cutting edge 1116 of the adjacent cell piece 111 is located, and the chamfer edge 1115 of the adjacent cell piece 111 is stacked on the backlight surface 1113 of the side on which the cutting edge 1116 of another cell piece 111 adjacent thereto is located.

That is, observing from the light-receiving surface of the cell piece 111, the chamfer edge 1115 of any one of the cell pieces 111 is stacked on the backlight surface on the side on which the cutting edge 1116 of the cell piece 111 adjacent to the cell piece 111 is located.

Due to in the lamination process of the cell module, a pressure direction of the cell module is from the backlight surface 1113 of the cell piece 111 to the light-receiving surface 1114. When the adjacent cell pieces 111 are locally stacked with each other, if the side on which the cutting edge 1116 of the cell piece 111 is located is pressed on the backlight surface 1113 of the chamfer edge 1115 of the cell piece 111 adjacent to the cell piece 111, a region of a corner position of the side on which the cutting edge 1116 of the cell piece 111 pressed above is located is in a suspended state due to the lack of support below. In the lamination process, uneven stress of the cell piece 111 is caused, easily increasing the risks of fragments, hidden cracks, and the like of the cell piece 111. While by using the manner that the chamfer edge 1115 of the cell piece 111 is stacked on the backlight surface of the side on which the cutting edge 1116 of the adjacent cell piece 111 is located and the chamfer edge 1115 of the adjacent cell piece 111 is stacked on the backlight surface 1113 of the side on which the cutting edge 1116 of the cell piece 111 is located, the chamfer edge 1115 of the cell piece 111 pressed above is even in stress, and a suspended region is not present, such that the risks of fragments, hidden cracks, and the like can be effectively reduced, and a production yield and the reliability of the cell module are improved.

Embodiment X

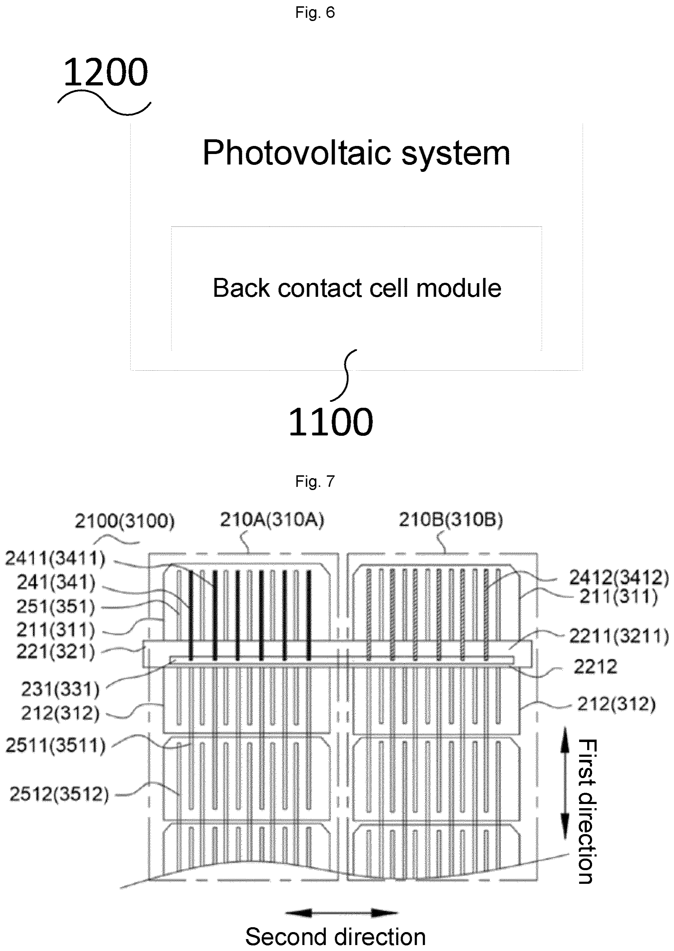

Referring to Fig. 6, a photovoltaic system 1200 provided in an implementation of the present disclosure includes the back contact cell module 1100 described in any one of the above implementations.

In the back contact cell module 1100 and the photovoltaic system 1200 of the implementations of the present disclosure, the back contact cell module 1100 includes a cell string 110, an insulation bar 120, and a bus bar 130. The cell string 110 includes a plurality of cell pieces 111 in series connection, and the plurality of cell pieces 111 are provided in a first direction; the insulation bar 120 is provided on a backlight surface 1113 of the cell piece 111 in a second direction; the first direction intersects the second direction; the bus bar 130 is, in the second direction, provided on a side of the insulation bar 120 facing away from the cell piece 111; and the insulation bar 120 covers the bus bar 130. Therefore, the bus bar 130 is hidden on backlight surfaces 1113 of the plurality of cell pieces 111, and cannot be observed from light-receiving surfaces 1114, such that a front side of the back contact cell module 1100 has a uniform and attractive color. Moreover, the insulation bar 120 can be provided between the bus bar 130 and the cell piece 111, thereby avoiding the problem of short circuits.

In this embodiment, the photovoltaic system 1200 can be applied to a photovoltaic power station such as a surface power station, a rooftop power station, a water surface power station, etc., or can also be applied to a device or an apparatus that uses solar energy for power generation, such as a user solar power supply, a solar street lamp, a solar car, a solar building, etc. Definitely, it can be understood that, the application scenarios of the photovoltaic system 1200 are not limited thereto, that is, the photovoltaic system 1200 can be used in all fields where solar energy is required for power generation. By using a photovoltaic power generation system network as an example, the photovoltaic system 1200 can include a photovoltaic array, a combiner box, and an inverter. The photovoltaic array can be an array combination of a plurality of cell assemblies. For example, the plurality of cell assemblies can constitute a plurality of photovoltaic arrays. The photovoltaic array is connected to the combiner box. The combiner box can converge currents generated by the photovoltaic array, and the converged currents are converted into alternating currents required by the municipal power grid by passing through the inverter, and then are connected to the municipal power network, so as to realize solar power supply.

Embodiment XI

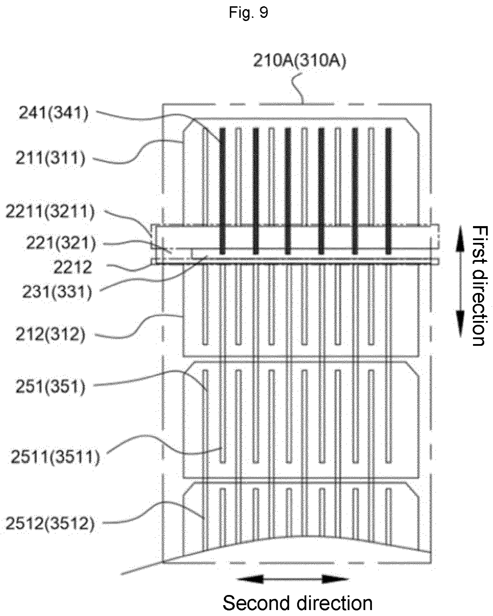

Referring to Fig. 7 to Fig. 9, this embodiment discloses a back contact cell module, including a cell string, a first insulation bar, a first bus bar, and a second ribbon A.

The cell string includes cell pieces serially connected to each other, where the cell pieces include a fifth cell piece 211 and a sixth cell piece 212, which are provided in a first direction; and the fifth cell piece 211 is provided on an end of the cell string.

The first insulation bar 221 is provided on an end of the sixth cell piece 212 close to the fifth cell piece 211.

The first bus bar 231 is provided on a side (i.e., a rear side of the first insulation bar 221, conversely, a side of the first insulation bar 221 facing toward the sixth cell piece 212 is a front side of the first insulation bar 221) of the first insulation bar 221 facing away from the sixth cell piece 212, wherein the first insulation bar 221 and the first bus bar 231 both extend in a second direction, and the first direction intersects the second direction.

The second ribbon A241 is configured to electrically connect the first bus bar 231 and the fifth cell piece 211.

In the first direction, a first widened section 2211 and a second widened section 2212, which extend outside an edge of the first bus bar 231, are provided on two ends of the first insulation bar 221; the first widened section 2211 and the second widened section 2212 are provided in sequence in a direction away from the fifth cell piece 211; and a width of the second widened section 2212 is less than a width of the first widened section 2211.

It can be understood that, an electrical connection mode can be soldering, bonding through a conductive adhesive, etc., but is not limited herein.

It can be understood that, in the cell string, the cell string can include two cell pieces connected in series, three cell pieces connected in series, or other higher number of cell pieces. The number of the cell pieces required to be connected in series can be determined according to actual use situations.

In the present disclosure, the first bus bar 231 is an end bus bar, and the fifth cell piece 211 is located on the end of the cell string. For ease of description, in the present disclosure, the end on which the fifth cell piece 211 is located is recorded as a tail end of the cell string. That is, in the first direction, the fifth cell piece 211 is the last cell piece of the cell string, and the sixth cell piece 212 is the penultimate cell piece of the cell string. It is not difficult to understand, the end on which the fifth cell piece 211 is located can also be recorded as a head end of the cell string, and details are not described herein again.

Optionally, in the same cell string, the adjacent cell pieces can be serially connected by soldering, the conductive adhesive, etc.

In an embodiment, the adjacent cell pieces are connected through series-connected ribbons 251 (in other embodiments, for example, in Embodiment I, referred to as "first ribbon"). Specifically, the series-connected ribbons 251 include a first series-connected ribbon 2511 and a second series-connected ribbon 2512. In the first direction, the first series-connected ribbon 2511 and the second series-connected ribbon 2512 are provided in a staggered manner. In the second direction, the first series-connected ribbon 2511 and the second series-connected ribbon 2512 are provided in a staggered manner. In one cell string, Nth cell piece, (N+1)th cell piece, and (N+2)th cell piece (N is a positive integer greater than 1) are sequentially provided in the first direction. A anode solder joint of the Nth cell piece is serially connected to a cathode solder joint of the (N+1)th cell piece through a plurality of first series-connected ribbons 2511, and a anode solder joint of the (N+1)th cell piece is serially connected to a cathode solder joint of the (N+2)th cell piece through a plurality of second series-connected ribbons 2512.

During assembly, the cell pieces in the cell string are serially connected to each other. The first insulation bar 221 is provided on the end of the sixth cell piece 212 close to the fifth cell piece 211. The first bus bar 231 is provided on the rear side of the first insulation bar 221. A main body of the second ribbon A241 is electrically connected to an effective soldering position of the fifth cell piece 211. The end of the second ribbon A241 close to the sixth cell piece 212 is electrically connected to the first bus bar 231. Therefore, the first bus bar 231 can extract a current of the cell string.

First, in the present disclosure, the first bus bar 231 is provided on the sixth cell piece 212, and the first bus bar 231 is separated from the sixth cell piece 212 through the first insulation bar 221. In an aspect, a space for placing the bus bar does not need to be reserved in an edge of the cell module, the cell module can reserve more spaces to mount the cell pieces, such that the effective light-receiving area of the cell module is larger, and assembly conversion efficiency is higher. In another aspect, observing from the light-receiving surface (or referred to as "front side") of the cell piece, the first insulation bar 221 can cover the first bus bar 231 to prevent the first bus bar 231 from exposing, thereby making the entire cell module more aesthetic.

Next, compared to a bus bar provided in an intermediate position of a rear side of the cell piece, the first bus bar 231 of the present disclosure is provided on the end of the sixth cell piece 212 close to the fifth cell piece 211, the second ribbon A241 can be fully attached to and soldered with an effective soldering position of the fifth cell piece 211, such that the insufficient soldering between the second ribbon A241 and the fifth cell piece 211 caused by the mounting of the first bus bar 231 is prevented from affecting collection of currents. Moreover, the second ribbon A241 can be directly connected to the first bus bar 231 after being soldered with the fifth cell piece 211, without perforating the insulation bar or replacing the insulation bar with insulation blocks provided intermittently. During assembly, the entire first insulation bar 221 only needs to be placed on the end of the sixth cell piece 212 close to the fifth cell piece 211, such that production accuracy requirements and production difficulty are effectively reduced, and position offset occurring when the insulation bar is perforated or position offset occurring during lamination of the insulation blocks can be avoided, thereby improving a product yield.

Moreover, the first insulation bar 221 of the present disclosure is provided with a first widened section 2211 and a second widened section 2212. That is, both sides of the first insulation bar 221 in the first direction are reserved with widened portions exceeding the edge of the first bus bar 231. Through the arrangement of the first widened section 2211 and the second widened section 2212, in an aspect, during preparation, the first insulation bar 221 can be allowed to offset to a certain extent in a width direction relative to the first bus bar 231 or relative to two cell pieces, thereby reducing production accuracy requirements and production difficulty. In another aspect, the second widened section 2212 in the first insulation bar 221 of the present disclosure is less than the first widened section 2211. That is, in the first direction, the first bus bar 231 is offset relative to the first insulation bar 221, rather than being centered symmetrically. Such arrangement can form the relatively-wide first widened section 2211 and relatively-narrow second widened section 2212. According to the relatively-wide first widened section 2211, the first widened section 2211 can cover more areas of the edge of the fifth cell piece 211 and the edge of the sixth cell piece 212, such that the risk of a short circuit caused by a contact between the first bus bar 231 and an shaped interconnect ribbon or asymmetric grid lines on the fifth cell piece 211 can be better reduced, the risk of a short circuit caused by a contact between the second ribbon A241 and an shaped interconnect ribbon or asymmetric grid lines on the sixth cell piece 212 can be better reduced, and the risk of short circuits easily caused by conductive foreign matters such as tin residues during preparation can be reduced, thereby improving the reliability of the cell module. According to the relatively-narrow second widened section 2212, an impact of the second widened section 2212 on a bifaciality of the cell module is reduced while it ensures that the above production accuracy requirements and short-circuit risks are reduced, thereby ensuring the cell module has a high bifaciality.

Furthermore, when the bus bar is provided on an outer edge, which is the end of the fifth cell piece 211 away from the sixth cell piece 212, of the last cell piece of the cell string, since the outer edge of the last cell piece of the cell string is close to an edge of the cell module, stress at the place is relatively large during lamination, easily leading to undesirable effects such as fragments. Moreover, the mounting of the bus bar affects the soldering between the second ribbon A241 and the fifth cell piece 211. In a position in which the bus bar is covered, the second ribbon A241 cannot be soldered with the fifth cell piece 211, leading to insufficient soldering between the second ribbon A241 and the fifth cell piece 211 and poor current collection, and this situation is particularly serious when the cell module is a back contact cell module without a busbar.

Relatively speaking, the end bus bar in-built structure of the present disclosure can be suitable for a back contact cell module with a busbar and the back contact cell module without the Busbar, and thus is stronger in universality. The end of the sixth cell piece 212 close to the fifth cell piece 211 has smaller stress during lamination compared to the outer edge of the last cell piece of the cell string, such that the risks of fragments and cracks can be reduced, thereby further improving the reliability of the cell module.

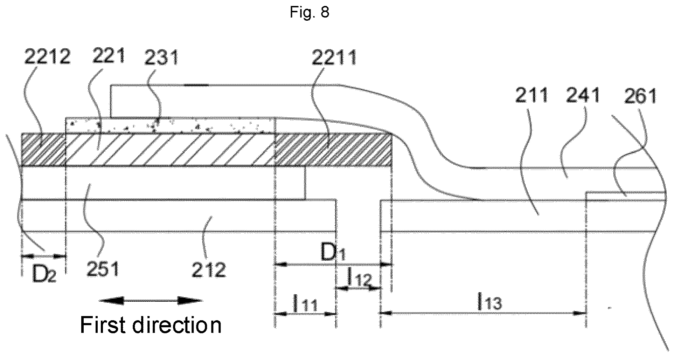

**In** some embodiments, referring to Fig. 8, at least a portion of the first widened section 2211 extends outside an edge of the sixth cell piece 212. Therefore, on the basis of allowing the first insulation bar 221 to offset to a certain extent during preparation in the width direction relative to the first bus bar 231, as well as relative to two cell pieces, it can also ensure that the first widened section 2211 can cover more areas of the edge of the fifth cell piece 211 and the edge of the sixth cell piece 212, such that the risks of short circuits caused by a contact between the first bus bar 231 or the second ribbon A241 and the shaped interconnect ribbon or asymmetric grid lines can be reduced, thereby improving the reliability of the cell module.

In some embodiments, referring to Fig. 8, in the first direction, an orthographic projection of the first widened section 2211 in a thickness direction of the sixth cell piece 212 is at least partially overlapped with an orthographic projection of the fifth cell piece 211 in the thickness direction of the sixth cell piece 212.

Therefore, the first insulation bar 221 can cover the edges of the sixth cell piece 212 and fifth cell piece 211, the short circuit caused by the contact between the first bus bar 231 and the shaped interconnect ribbon or asymmetric grid lines on the fifth cell piece 211 can be avoided, and the short circuit caused by the contact between the second ribbon A241 and the shaped interconnect ribbon or asymmetric grid lines of the sixth cell piece 212 can also be avoided, thereby further reducing the risks of short circuits.

In particular, when the cell piece is cut into half pieces, the cutting edge easily leads to a short circuit after cutting. The arrangement of the first widened section 2211 of the present disclosure can effectively avoid the short circuit easily caused by the cutting edge, such that the reliability of the cell module can also be ensured by disposing the half cutting edge of the cell on the side on which the first bus bar231 is located or on the side of the adjacent cell piece close to the first bus bar 231.

In some embodiments, referring to Fig. 8, optionally, in the first direction, the width of the second widened section 2212 is $D_2 \geq 1$ mm.

When the second widened section 2212 is too small, an amount that the first insulation bar 221 is allowed to offset during preparation is small, resulting in higher production accuracy requirements. When the width of the second widened section 2212 of this embodiment is controlled to be $\geq 1$ mm, sufficient offset spaces can be reserved for a equipment leveling tolerance during preparation and a tolerance of bus bar offset during lamination, thereby reducing the production accuracy requirements.

In some embodiments, referring to Fig. 8, the fifth cell piece 211 and the sixth cell piece 212 are provided on the same plane.

$$1 \text{ mm} < D_1 \leq l_{11} + l_{12} + l_{13}$$

In the formula, $D_1$ is the width of the first widened section 2211 in the first direction, $l_{11}$ is, in the first direction, a relative width distance between the first bus bar 231 and the edge of the sixth cell piece 212 close to an end of the fifth cell piece 211, $l_{12}$ is a space between the fifth cell piece 211 and the sixth cell piece 212, $l_{13}$ is a relative width distance between the edge of the fifth cell piece 211 close to an end of the sixth cell piece 212 and a first solder joint 261, and the first solder joint 261 is provided on the end of the fifth cell piece 211 close to the sixth cell piece 212, so as to be connected to the second ribbon A241.

It can be understood that, if $l_{11} + l_{12} > 1$ mm and $l_{11+} < 1$ mm, $D_1 > 1$ mm is controlled, such that while it ensures that the first widened section 2211 can extend to cover the edge region of the fifth cell piece 211 and the edge region of the sixth cell piece 212, sufficient offset spaces are reserved for the equipment leveling tolerance during preparation and the tolerance of bus bar offset during lamination. Therefore, the first insulation bar 221 can be allowed to offset slightly in the width direction relative to the first bus bar 231, as well as relative to two cell pieces.

It can be understood that, the first solder joint 261 is located on the edge (i.e., the outermost connection point of the second ribbon A241 on the fifth cell piece 211 ) of the effective soldering position of the fifth cell piece 211 closest to the sixth cell piece 212. The first solder joint 261 can be a grid line or a bonding pad, which is not limited herein.

When the width of the first widened section 2211 is too small, the risk of short circuits is increased, and the reliability of the cell module is reduced. As the width of the first widened section 2211 increases, the reliability of the cell module is improved, the allowed displacement deviation of the first insulation bar 221 during preparation in the width direction relative to the first bus bar 231, as well as relative to two cell pieces increases, and the production accuracy requirements are reduced. However, when the width of the first widened section 2211 is too large, sufficient soldering between the second ribbon A241 and the effective soldering position on the fifth cell piece 211 is affected, a current collection effect is reduced, and the bifaciality of the cell module is affected. In this embodiment, 1 mm$< D_1 \leq l_{11} + l_{12} + l_{13}$ is controlled to ensure that, on the basis of allowing the first insulation bar 221 to offset to a certain extent during preparation, the first widened section 2211 of the first insulation bar 221 can extend further to cover the edge region of the fifth cell piece 211 and the edge region of the sixth cell piece 212, thereby further improving the reliability and production yield of the cell module, and reducing the production accuracy requirements. Moreover, sufficient soldering between the second ribbon A241 and the effective soldering position on the fifth cell piece 211 can be prevented from being affected, without resulting in unnecessary material waste and loss of the bifaciality.

In an embodiment, in the first direction, the end of the first bus bar 231 close to the fifth cell piece 211 extends outside the edge of the sixth cell piece 212.

In another embodiment, referring to Fig. 8, in the first direction, an orthographic projection of the first bus bar 231 in a thickness direction of the sixth cell piece 212 falls in the sixth cell piece 212. That is, the first bus bar 231 is provided within the edge of the sixth cell piece 212.

In some embodiments, referring to Fig. 7, Fig. 9, and Fig. 10, the cell module includes at least one series-connected cell string group 2100. The same series-connected cell string group 2100 includes two cell strings that are provided in the second direction and serially connected to each other; and the same series-connected cell string group 2100 extends from the sixth cell piece 212 in one cell string to the sixth cell piece 212 of the other cell string through the same first bus bar 231.

Optionally, the second ribbon A241 includes a first anode ribbon 2411 and a first cathode ribbon 2412. The same first bus bar 231 is electrically connected to the first anode ribbon 2411 in one cell string and is electrically connected to the first cathode ribbon 2412 in the other cell string, so as to form a serial connection between the adjacent cell pieces.

Exemplarily, the same series-connected cell string group 2100 includes a first cell string 210A and a second cell string 210B. The second ribbon A241 includes the first anode ribbon 2411 and the first cathode ribbon 2412. In the same series-connected cell string group 2100, the same first bus bar 231 extends from the sixth cell piece 212 in the first cell string 210A to the sixth cell piece 212 in the second cell string 210B. Moreover, in the first cell string 210A, the first bus bar 231 is electrically connected to the first anode ribbon 2411 on the fifth cell piece 211, and in the second cell string 210B, the first bus bar 231 is electrically connected to the first cathode ribbon 2412 on the fifth cell piece 211.

In an embodiment, the cell module includes a parallel-connected cell string group 2200. the same parallel-connected cell string group 2200 includes at least two cell strings that are provided in a first direction and parallelly connected to each other, and a spacing region is provided between two cell strings parallelly connected to each other. An intermediate bus bar 232 is provided in the spacing region. The intermediate bus bar 232 is configured to parallelly connect two cell strings adjacent to each other in the first direction, that is, the end bus bar in-built structure of the present disclosure can be mated with a mounting structure of a conventional intermediate bus bar 232.

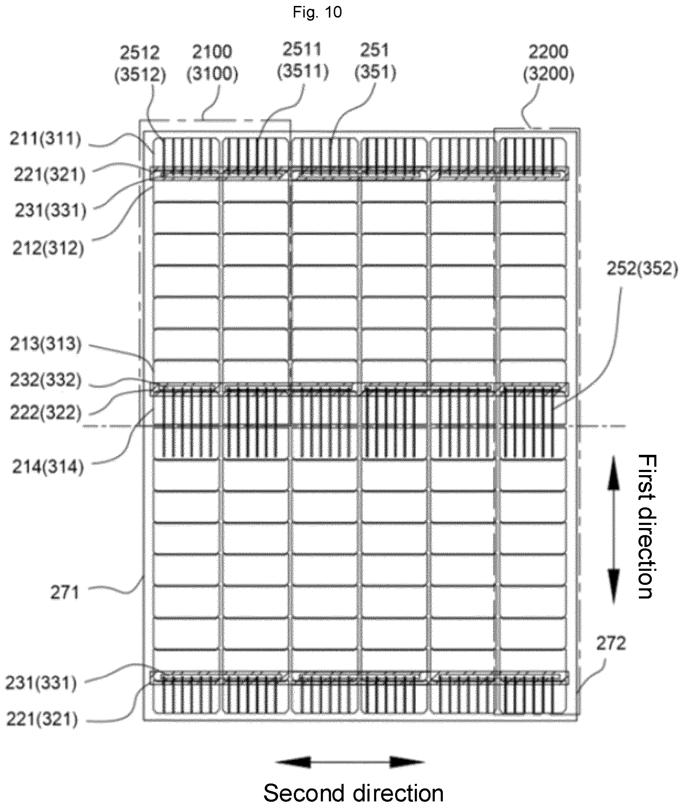

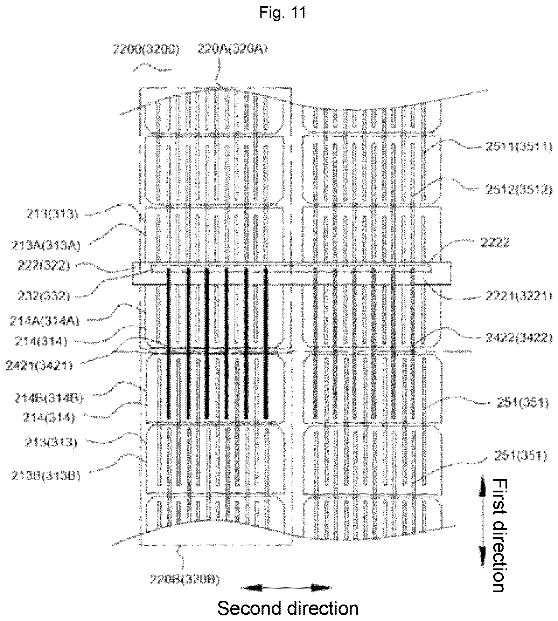

In another embodiment, referring to Fig. 10 and Fig. 11, a fourth cell piece 214 is provided on an end of each cell string away from the fifth cell piece 211, and a third cell piece 213 is provided on an end of the fourth cell piece 214 close to the fifth cell piece 211.

The back contact cell module further includes a second insulation bar, an intermediate bus bar, and a second ribbon B.

The second insulation bar 222 is provided on an edge of the third cell piece 213 in one cell string and provided on an end of the third cell piece 213 close to the fourth cell piece 214.

The intermediate bus bar 232 is configured to parallelly connect two cell strings, which are adjacent to each other in the first direction. The intermediate bus bar 232 is provided on a side of the second insulation bar 222 facing away from the third cell piece 213, and the second insulation bar 222 and the intermediate bus bar 232 both extend in the second direction.

The second ribbon B242 is configured to electrically connect the intermediate bus bar 232, the fourth cell piece 214 in the cell string, and the fourth cell piece 214 in another cell string adjacent to the cell string in the first direction.

Exemplarily, for ease of description, the third cell string 220A and the fourth cell string 220B parallelly connected to each other in the same parallel-connected cell string group 2200 are used as an example. The third cell string 220A is the cell string in which the intermediate bus bar 232 is located.

The third cell piece 213 in the third cell string 220A is recorded as the third cell piece 213A, and the fourth cell piece 214 is recorded as the fourth cell piece 214A; the third cell piece 213 in the fourth cell string 220B is recorded as the third cell piece 213B, and the fourth cell piece 214 is recorded as the fourth cell piece 214B; the third cell string 220A and the fourth cell string 220B are provided in the first direction; and the fourth cell piece 214A and the fourth cell piece 214B are adjacent to each other in the first direction.

The back contact cell module further includes the second insulation bar, the intermediate bus bar, and the second ribbon B.

The second insulation bar 222 is provided on an edge of the third cell piece 213A in the third cell string 220A and provided on an end of the third cell piece 213A close to the fourth cell piece 214A.

The intermediate bus bar 232 is configured to parallelly connect the third cell string 220A and the fourth cell string 220B. The intermediate bus bar 232 is provided on a side of the second insulation bar 222 facing away from the third cell piece 213, and the second insulation bar 222 and the intermediate bus bar 232 both extend in the second direction.

The second ribbon B242 is configured to electrically connect the intermediate bus bar 232, the fourth cell piece 214A, and the fourth cell piece 214B, that is, the same second ribbon B242 sequentially extends from the fourth cell piece 214B to the fourth cell piece 214A and the intermediate bus bar 232.

Optionally, the second ribbon B242 includes a second anode ribbon 2421 and a second cathode ribbon 2422. The fourth cell piece 214A, the fourth cell piece 214B, and the intermediate bus bar 232 are electrically connected through the second anode ribbon 2421 and the second cathode ribbon 2422.

According to the intermediate bus bar 232 in-built structure of the present disclosure, in an aspect, an effective light-receiving area of the cell module can be increased, assembly conversion efficiency is improved, and the intermediate bus bar 232 is prevented from being exposed, thus making the entire cell module more aesthetic. In another aspect, it can ensure that the second ribbon B242 can be fully attached to and soldered with an effective soldering position of the fourth cell piece 214, such that the insufficient soldering between the second ribbon B242 and the fourth cell piece 214 caused by the mounting of the intermediate bus bar 232 is prevented from affecting collection of currents. During assembly, the entire first insulation bar 221 only needs to be placed on the end of the third cell piece 213 close to the fourth cell piece 214. Furthermore, the intermediate bus bar 232 in-built structure of the present disclosure can be suitable for the back contact cell module with the Busbar and the back contact cell module without the Busbar, and thus is stronger in universality. The intermediate bus bar 232 in-built structure has smaller stress during lamination, such that the risks of hidden cracks and fragments of the cell piece can be reduced, thereby achieving the good reliability of the back contact cell module.

The end bus bar in-built structure of the present disclosure is mated with the intermediate bus bar 232 in-built structure of the present disclosure, such that the effective light-receiving area of the cell module can be increased, the assembly conversion efficiency is improved, the aesthetics and reliability of the entire cell module are better, and the production accuracy requirements and production difficulty are effectively reduced, thereby improving production efficiency.

In some embodiments, referring to Fig. 10 and Fig. 11, in the first direction, a first protruding segment 2221 and a second protruding segment 2222, which extend outside an edge of the intermediate bus bar 232, are provided on two ends of the second insulation bar 222; the first protruding segment 2221 and the second protruding segment 2222 are provided in sequence along a direction away from the fourth cell piece 214; at least a portion of the first protruding segment 2221 extends outside an edge of the third cell piece 213; and a width of the second protruding segment 2222 is less than a width of the first protruding segment 2221.

Through the arrangement of the first protruding segment 2221 and the second protruding segment 2222 of the second insulation bar 222, in an aspect, during preparation, the second insulation bar 222 is allowed to offset to a certain extent in the width direction relative to the intermediate bus bar 232 or relative to two cell pieces, thereby reducing production accuracy requirements and production difficulty. In another aspect, the relatively-wide first protruding segment 2221 and the relatively-narrow second protruding segment 2222 are formed on the second insulation bar 222. According to the relatively-wide first protruding segment 2221, the first protruding segment 2221 can cover more areas of the edge of the fourth cell piece 214A and the edge of the third cell piece 213A, such that the risk of a short circuit caused by a contact between the intermediate bus bar 232 and an shaped interconnect ribbon or asymmetric grid lines on the fourth cell piece 214A can be better reduced, and the risk of a short circuit caused by a contact between the second ribbon B242 and an shaped interconnect ribbon or asymmetric grid lines of the third cell piece 213A can be reduced, thereby improving the reliability of the cell module. According to the relatively-narrow second protruding segment 2222, an impact of the second protruding segment 2222 on the bifaciality of the cell module is reduced while it ensures that the above production accuracy requirements and short-circuit risks are reduced, thereby ensuring the cell module has a high bifaciality.

In some embodiments, referring to Fig. 10, the cell module further includes a front sheet. The cell string is provided on the front sheet, the front sheet is provided with a first edge 271 and a second edge 272 provided along the second direction, and an orthographic projection of the first insulation bar 221 in a thickness direction of the sixth cell piece 212 falls between the first edge 271 and the second edge 272.

If the first insulation bar 221 exceeds the first edge 271 or the second edge 272, material layers such as an adhesive film, the front sheet, a backsheet, and the like of the cell module cannot be fully compounded, especially an edge region, causing external moisture to easily invade inside the cell module, thus affecting the reliability of the cell module.

This embodiment further provides a photovoltaic system, including the above back contact cell module.

Embodiment XII

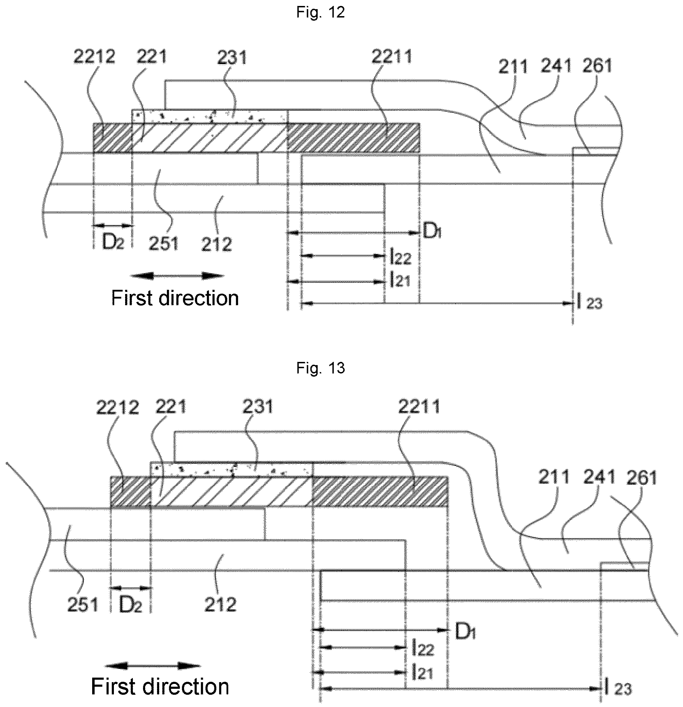

A difference between this embodiment and Embodiment XI lies in that, referring to Fig. 12 to Fig. 14, the end of the sixth cell piece 212 close to the fifth cell piece 211 is at least partially stacked with the fifth cell piece 211, that is, the fifth cell piece 211 and the sixth cell piece 212 are arranged in a shingled configuration, and there is no gap between the two cell pieces.

$$1 \text{ mm} < D_1 \leq I_{21} + I_{23} - I_{22}$$

In the formula, $D_1$ is the width of the first widened section 2211 in the first direction, $I_{21}$ is, in the first direction, a relative width distance between the first bus bar 231 and the edge of the sixth cell piece 212 close to an end of the fifth cell piece 211, $I_{22}$ is, in the first direction, a width of a stacking region between the fifth cell piece 211 and the sixth cell piece 212, $I_{23}$ is a relative width distance between the edge of the fifth cell piece 211 close to an end of the sixth cell piece 212 and a first solder joint 261, and the first solder joint 261 is provided on the end of the fifth cell piece 211 close to the sixth cell piece 212, so as to be connected to the second ribbon A241.

In an embodiment, referring to Fig. 12, the side of the sixth cell piece 212 facing away from the first insulation bar 221 is at least partially stacked with the fifth cell piece 211.

In another embodiment, referring to Fig. 13, the side of the sixth cell piece 212 facing toward the first insulation bar 221 is at least partially stacked with the fifth cell piece 211.

It can be understood that, if $I_{21} + I_{22} > 1$ mm and $I_{21} < 1$ mm, $D_1 > 1$ mm is controlled, such that while it ensures that the first widened section 2211 can extend to cover the edge region of the fifth cell piece 211 and the edge region of the sixth cell piece 212, sufficient offset spaces are reserved for the equipment leveling tolerance during preparation and the tolerance of bus bar offset during lamination. Therefore, the first insulation bar 221 can be allowed to offset slightly in the width direction relative to the first bus bar 231, as well as relative to two cell pieces.

When the width of the first widened section 2211 is too small, the risk of short circuits is increased, and the reliability of the cell module is reduced. As the width of the first widened section 2211 increases, the reliability of the cell module is improved, the allowed displacement deviation of the first insulation bar 221 during preparation in the width direction relative to the first bus bar 231, as well as relative to two cell pieces increases, and the production accuracy requirements are reduced. However, when the width of the first widened section 2211 is too large, sufficient soldering between the second ribbon A241 and the effective soldering position on the fifth cell piece 211 is affected, a current collection effect is reduced, and the bifaciality of the cell module is affected. In this embodiment, $1 \text{ mm} < D_1 \leq I_{21} + I_{22} + I_{23}$ is controlled to ensure that, on the basis of allowing the first insulation bar 221 to offset to a certain extent during preparation, the first widened section 2211 of the first insulation bar 221 can extend to cover the edge region of the fifth cell piece 211 and the edge region of the sixth cell piece 212, thereby further improving the reliability and production yield of the cell module, and reducing the production accuracy requirements. Moreover, sufficient soldering between the second ribbon A241 and the effective soldering position on the fifth cell piece 211 can be prevented from being affected, without resulting in unnecessary material waste and loss of the bifaciality.

Those skilled in the art can readily understand that, for the sake of convenience and brevity, the structure and implementation principles of the back contact cell described above can be referenced from the corresponding structure and implementation principles in the aforementioned Embodiment XIII, and are not be described herein again.

Embodiment XIII

Referring to Fig. 11 to Fig. 15, this embodiment discloses a back contact cell module, including a parallel-connected cell string group, a second insulation bar, an intermediate bus bar, and a second ribbon B.

The same parallel-connected cell string group 2200 includes at least two cell strings that are provided in a first direction and parallelly connected to each other, each cell string includes cell pieces serially connected to each other, the series-connected cell pieces include a third cell piece 213 and a fourth cell piece 214 provided in the first direction, the fourth cell piece 214 is provided on an end of the cell string, and the fourth cell pieces 214 in the two parallel-connected cell strings are adjacent to each other in the first direction.

The second insulation bar 222 is provided on an edge of the third cell piece 213 in one cell string and provided on an end of the third cell piece 213 close to the fourth cell piece 214.

The intermediate bus bar 232 is configured to parallelly connect two cell strings, which are adjacent to each other in the first direction. The intermediate bus bar 232 is provided on a side of the second insulation bar 222 facing away from the third cell piece 213, and the second insulation bar 222 and the intermediate bus bar 232 both extend in the second direction.

The second ribbon B242 is configured to electrically connect the intermediate bus bar 232, the fourth cell piece 214 in the cell string in which the intermediate bus bar 232 is located, and the fourth cell piece 214 in another cell string adjacent to the cell string in the first direction.

In the first direction, a first protruding segment 2221 and a second protruding segment 2222, which extend outside an edge of the intermediate bus bar 232, are provided on two ends of the second insulation bar 222; the first protruding segment 2221 and the second protruding segment 2222 are provided in sequence in a direction away from the fourth cell piece 214; and a width of the second protruding segment 2222 is less than a width of the first protruding segment 2221.

Exemplarily, for ease of description, the third cell string 220A and the fourth cell string 220B parallelly connected to each other in the same parallel-connected cell string group 2200 are used as an example. The third cell string 220A is the cell string in which the intermediate bus bar 232 is located.

The third cell piece 213 in the third cell string 220A is recorded as the third cell piece 213A, and the fourth cell piece 214 is recorded as the fourth cell piece 214A; the third cell piece 213 in the fourth cell string 220B is recorded as the third cell piece 213B, and the fourth cell piece 214 is recorded as the fourth cell piece 214B; the third cell string 220A and the fourth cell string 220B are provided in the first direction; and the fourth cell piece 214A and the fourth cell piece 214B are adjacent to each other in the first direction.

The cell module further includes the second insulation bar, the intermediate bus bar, and the second ribbon B.

The second insulation bar 222 is provided on an edge of the third cell piece 213A in the third cell string 220A and provided on an end of the third cell piece 213A close to the fourth cell piece 214A.

The intermediate bus bar 232 is configured to parallelly connect the third cell string 220A and the fourth cell string 220B. The intermediate bus bar 232 is provided on a side of the second insulation bar 222 facing away from the third cell piece 213, and the second insulation bar 222 and the intermediate bus bar 232 both extend in the second direction.

The second ribbon B242 is configured to electrically connect the intermediate bus bar 232, the fourth cell piece 214A, and the fourth cell piece 214B, that is, the same second ribbon B242 sequentially extends from the fourth cell piece 214B to the fourth cell piece 214A and the intermediate bus bar 232.

In some embodiments, an extended portion extending outside the edge of the third cell piece 213A is provided on the end of the second insulation bar 222 close to the fourth cell piece 214A; and in a thickness direction of the third cell piece 213A, an orthographic projection of the extended portion is at least partially overlapped with an orthographic projection of the fourth cell piece 214A. In some other embodiments, an extended portion is provided on the end of the intermediate bus bar 232 close to the fourth cell piece 214A. The extended portion extends outside the edge of the second insulation bar 222 in the first direction, and is electrically connected to the second ribbon B242. A terminal is formed at a junction between the extended portion and the second ribbon B242.

In this way, during assembly, the cell pieces in the cell string are serially connected to each other. The second insulation bar 222 is provided on the end of the third cell piece 213A close to the fourth cell piece 214A. The intermediate bus bar 232 is provided on the rear side of the second insulation bar 222. A main body of the second ribbon B242 is electrically connected to the effective soldering position of the fourth cell piece 214A and the effective soldering position of the fourth cell piece 214B, respectively. The end of the second ribbon B242 close to the third cell piece 213A is electrically connected to the intermediate bus bar 232. Therefore, the intermediate bus bar 232 can be parallelly connected to the third cell string 220A and the fourth cell string 220B.

First, in the embodiments of the present disclosure, the intermediate bus bar 232 is provided on the third cell piece 213A, and the intermediate bus bar 232 is separated from the third cell piece 213A through the second insulation bar 222. In an aspect, a space for placing the bus bar does not need to be reserved in an edge of the cell module, the cell module can reserve more spaces to mount the cell pieces, such that the effective light-receiving area of the cell module is larger, and assembly conversion efficiency is higher. In another aspect, observing from the light-receiving surface (or referred to as "front side") of the cell piece, the second insulation bar 222 can cover the intermediate bus bar 232, thereby making the entire cell module more aesthetic.

Then, compared to a bus bar provided in an intermediate position of a rear side of the cell piece, the intermediate bus bar 232 of this embodiment of the present disclosure is provided on the end of the third cell piece 213A close to the fourth cell piece 214A, the second ribbon B242 extends to the fourth cell piece 214A after being connected to the effective soldering position of the fourth cell piece 214B, and can be fully attached to and soldered with the effective soldering position of the fourth cell piece 214A, such that the insufficient soldering between the second ribbon B242 and the fourth cell piece 214A caused by the mounting of the intermediate bus bar 232 is prevented from affecting collection of currents. Moreover, the second ribbon B242 can be directly connected to the intermediate bus bar 232 after being soldered with the fourth cell piece 214A and the fourth cell piece 214B, without perforating the insulation bar or replacing the insulation bar with insulation blocks provided intermittently. During assembly, the entire second insulation bar 222 only needs to be placed on the end of the third cell piece 213A close to the fourth cell piece 214A, such that production accuracy requirements and production difficulty are effectively reduced, and position offset occurring when the insulation bar is perforated or position offset occurring during lamination of the insulation blocks can be avoided, thereby improving a product yield.

Moreover, the second insulation bar 222 of the present disclosure is provided with a first protruding segment 2221 and a second protruding segment 2222. That is, both sides of the second insulation bar 222 in the first direction are reserved with widened portions exceeding the edge of the intermediate bus bar 232. Through the arrangement of the first protruding segment 2221 and the second protruding segment 2222, in an aspect, during preparation, the second insulation bar 222 is allowed to offset to a certain extent in the width direction relative to the intermediate bus bar 232 or relative to two cell pieces, thereby reducing production accuracy requirements and production difficulty. In another aspect, the second protruding segment 2222 in the second insulation bar 222 of this embodiment of the present disclosure is less than the first protruding segment 2221. That is, in the first direction, the intermediate bus bar 232 is offset relative to the second insulation bar 222, rather than being centered symmetrically. Such arrangement can form the relatively-wide first protruding segment 2221 and relatively-narrow second protruding segment 2222. According to the relatively-wide first protruding segment 2221, the first protruding segment 2221 can cover more areas of the edge of the fourth cell piece 214A and the edge of the third cell piece 213A, such that the risk of a short circuit caused by a contact between the intermediate bus bar 232 and an shaped interconnect ribbon or asymmetric grid lines on the fourth cell piece 214A can be better reduced, and the risk of a short circuit caused by a contact between the second ribbon A241 and an shaped interconnect ribbon or asymmetric grid lines of the third cell piece 213A can be better reduced, thereby improving the reliability of the cell module. According to the relatively-narrow second protruding segment 2222, an impact of the second protruding segment 2222 on a bifaciality of the cell module is reduced while it ensures that the above production accuracy requirements and short-circuit risks are reduced, thereby ensuring the cell module has a high bifaciality.

Furthermore, when the bus bar is provided on an outer edge, which is the end of the fourth cell piece 214A away from the third cell piece 213A, of the last cell piece of the cell string, since the outer edge of the last cell piece of the cell string is laminated, stress at the place is relatively large, easily leading to undesirable effects such as fragments. Moreover, the mounting of the bus bar affects the soldering between the second ribbon B242 and the fourth cell piece 214A. **In** a position in which the bus bar is covered, the second ribbon B242 cannot be soldered with the fourth cell piece 214A, leading to insufficient soldering between the second ribbon B242 and the fourth cell piece 214A and poor current collection, and this situation is particularly serious when the cell module is a back contact cell module without a Busbar.

Relatively speaking, the intermediate bus bar 232 in-built structure of this embodiment of the present disclosure can be suitable for a back contact cell module with a Busbar and the back contact cell module without the Busbar, and thus is stronger in universality. Furthermore, in an aspect, the end of the third cell piece 213A close to the fourth cell piece 214A has smaller stress during lamination compared to the outer edge of the last cell piece of the cell string, such that the risks of hidden cracks and fragments can be further reduced, thereby further improving the reliability of the back contact cell module.

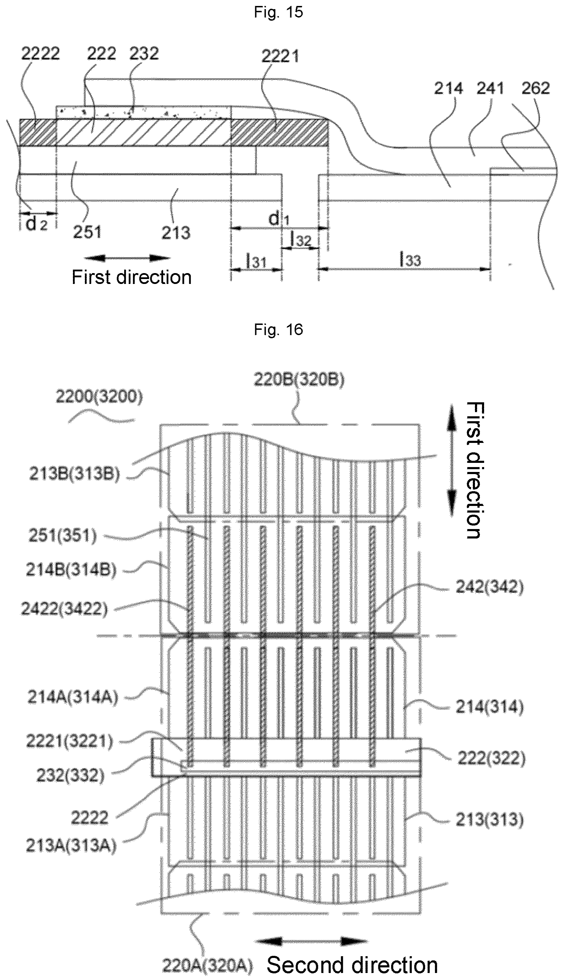

In some embodiments, referring to Fig. 15, at least a portion of the first protruding segment 2221 extends outside an edge of the third cell piece 213.

Therefore, on the basis of allowing the second insulation bar 222 to offset to a certain extent in the width direction relative to the intermediate bus bar 232, as well as relative to two cell pieces, it can also ensure that the first widened section 2211 can cover more areas of the edge of the fourth cell piece 214A and the edge of the third cell piece 213A, such that the risks of short circuits caused by a contact between the intermediate bus bar 232 or the second ribbon A241 and the shaped interconnect ribbon or asymmetric grid lines can be reduced, thereby improving the reliability of the cell module.

In some embodiments, referring to Fig. 15, in the first direction, an orthographic projection of the first protruding segment 2221 in a thickness direction of the third cell piece 213 is at least partially overlapped with an orthographic projection of the fourth cell piece 214 in the thickness direction of the third cell piece 213.

Therefore, the second insulation bar 222 can cover the edges of the third cell piece 213A and fourth cell piece 214A, the short circuit caused by the contact between the intermediate bus bar 232 and the shaped interconnect ribbon or asymmetric grid lines on the fourth cell piece 214A can be avoided, and the short circuit caused by the contact between the second ribbon B242 and the shaped interconnect ribbon or asymmetric grid lines of the third cell piece 213A can also be avoided, thereby further reducing the risks of short circuits.

In particular, when the cell piece is cut into half pieces, the cutting edge easily leads to a short circuit after cutting. The arrangement of the first protruding segment 2221 of this embodiment of the present disclosure can effectively avoid the short circuit easily caused by the cutting edge, such that the reliability of the cell module can also be ensured by disposing the half cutting edge of the cell on the side on which the intermediate bus bar 232 is located or on the side of the adjacent cell piece close to the intermediate bus bar 232.

In some embodiments, referring to Fig. 15, in the first direction, the width of the second protruding segment 2222 is $d_2 \geq 1$ mm.

When the second protruding segment 2222 is too small, an amount that the second insulation bar 222 is allowed to offset during preparation is small, resulting in higher production accuracy requirements. When the width of the second protruding segment 2222 of this embodiment is controlled to be $\geq 1$ mm, sufficient offset spaces can be reserved for a equipment leveling tolerance during preparation and a laminated offset tolerance of led-out holes of the bus bar, thereby reducing the production accuracy requirements.

In some embodiments, referring to Fig. 15, the fourth cell piece 214 and the third cell piece 213 are provided on the same plane.

$$1 \text{ mm} < d_1 \leq l_{31} + l_{32} + l_{33}$$

In the formula, $d_1$ is the width of the first protruding segment 2221 in the first direction; $l_{31}$ is, in the cell string in which the intermediate bus bar 232 is provided, and in the first direction, a relative width distance between the intermediate bus bar 232 and the edge of the third cell piece 213 close to an end of the fourth cell piece 214; $l_{32}$ is, in the cell string in which the intermediate bus bar 232 is provided, a space between the fourth cell piece 214 and the third cell piece 213; $l_{33}$ is, in the cell string in which the intermediate bus bar 232 is provided, a relative width distance between the edge of the fourth cell piece 214 close to an end of the third cell piece 213 and a second solder joint 262; and the second solder joint 262 is provided on the fourth cell piece 214 in the cell string in which the intermediate bus bar 232 is provided, and is provided on the end of the fourth cell piece 214 close to the third cell piece 213, so as to be connected to the second ribbon B242.

It can be understood that, the second solder joint 262 is located on the edge (i.e., the outermost connection point of the second ribbon B242 on the fourth cell piece 214A) of the effective soldering position of the fourth cell piece 214A closest to the third cell piece 213A. The second solder joint 262 can be a grid line or a bonding pad, which is not limited herein.

It can be understood that, if $l_{31}+l_{32}>1$ mm and $l_{31} < 1$ mm, $d_1 > 1$ mm is controlled, such that while it ensures that the first protruding segment 2221 can extend to cover the edge region of the fourth cell piece 214A and the edge region of the third cell piece 213A, sufficient offset spaces can be reserved for the equipment leveling tolerance during preparation and the laminated offset tolerance of the led-out holes of the bus bar. Therefore, the second insulation bar 222 can be allowed to offset slightly in the width direction relative to the intermediate bus bar 232, as well as relative to two cell pieces.

When the width of the first protruding segment 2221 is too small, the risk of short circuits is increased, and the reliability of the cell module is reduced. As the width of the first protruding segment 2221 increases, the reliability of the cell module is improved, the allowed displacement deviation of the second insulation bar 222 during preparation in the width direction relative to the intermediate bus bar 232, as well as relative to two cell pieces increases, and the production accuracy requirements are reduced. However, when the width of the first protruding segment 2221 is too large, sufficient soldering between the second ribbon B242 and the effective soldering position on the fourth cell piece 214A is affected, a current collection effect is reduced, and the bifaciality of the cell module is affected. In this embodiment, 1 mm$<d_1 \leq l_{31}+l_{32}+l_{33}$ is controlled to ensure that, on the basis of allowing the second insulation bar 222 to offset to a certain extent during preparation, the first protruding segment 2221 of the second insulation bar 222 can extend further to cover the edge region of the third cell piece 213A and the edge region of the fourth cell piece 214A, thereby further improving the reliability and production yield of the cell module, and reducing the production accuracy requirements. Moreover, sufficient soldering between the second ribbon B242 and the effective soldering position on the fourth cell piece 214A can be prevented from being affected, without resulting in unnecessary material waste and loss of the bifaciality.

In some embodiments, the cell module further includes a front sheet. The cell string is provided on the front sheet, the front sheet is provided with a first edge and a second edge in the second direction, and an orthographic projection of the second insulation bar 222 in a thickness direction of the third cell piece 213 falls between the first edge and the second edge.

If the second insulation bar 222 exceeds the first edge or the second edge, material layers such as an adhesive film, the front sheet, a backsheet, and the like of the cell module cannot be fully compounded, especially an edge region, causing external moisture to easily invade inside the cell module, thus affecting the reliability of the cell module.

Those skilled in the art can readily understand that, for the sake of convenience and brevity, the structure and implementation principles of the back contact cell described above can be referenced from the corresponding structure and implementation principles in the aforementioned Embodiment XIII, and are not be described herein again.

Embodiment XIV

A difference between this embodiment and Embodiment XIII lies in that, referring to Fig. 16 to Fig. 18, in the cell string in which the intermediate bus bar 232 is provided, the end of the third cell piece 213 close to the fourth cell piece 214 is at least partially stacked with the fourth cell piece 214, that is, the third cell piece 213A and the fourth cell piece 214A are arranged in a shingled configuration, and there is no gap between the two cell pieces.

$$1 \text{ mm} < d_1 \leq l_{41} + l_{43} - l_{42}$$

In the formula, $d_1$ is the width of the first protruding segment 2221 in the first direction; $l_{41}$ is, in the cell string in which the intermediate bus bar 232 is provided, and in the first direction, a relative width distance between the intermediate bus bar 232 and the edge of the third cell piece 213 close to an end of the fourth cell piece 214; $l_{42}$ is, in the first direction, a width of a stacking region between the third cell piece 213 and the fourth cell piece 214; $l_{43}$ is, in the cell string in which the intermediate bus bar 232 is provided, a relative width distance between the edge of the fourth cell piece 214 close to an end of the third cell piece 213 and a second solder joint 262; and the second solder joint 262 is provided on the end of the fourth cell piece 214 close to the third cell piece 213, so as to be connected to the second ribbon B242.

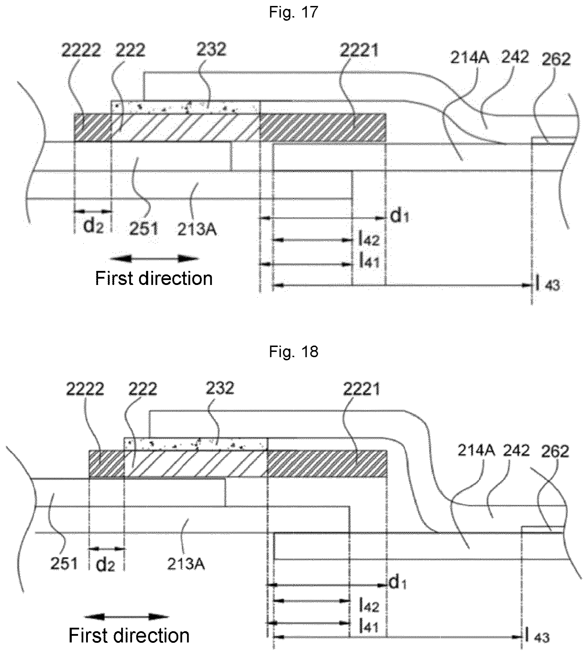

Referring to Fig. 17, in an embodiment, the side of the third cell piece 213A facing toward the first insulation bar 221 is at least partially stacked with the fourth cell piece 214A.

Referring to Fig. 18, in another embodiment, the side of the third cell piece 213A facing away from the second insulation bar 222 is at least partially stacked with the fourth cell piece 214A.

It can be understood that, if $l_{41} + l_{42} > 1$ mm and $l_{41} < 1$ mm, $d_1 > 1$ mm is controlled, such that while it ensures that the first protruding segment 2221 can extend to cover the edge region of the fourth cell piece 214A and the edge region of the third cell piece 213A, sufficient offset spaces can be reserved for the equipment leveling tolerance during preparation and the laminated offset tolerance of the led-out holes of the bus bar. Therefore, the second insulation bar 222 can be allowed to offset slightly in the width direction relative to the intermediate bus bar 232, as well as relative to two cell pieces.

When the width of the first protruding segment 2221 is too small, the risk of short circuits is increased, and the reliability of the cell module is reduced. As the width of the first protruding segment 2221 increases, the reliability of the cell module is improved, the allowed displacement deviation of the second insulation bar 222 during preparation in the width direction relative to the intermediate bus bar 232, as well as relative to two cell pieces increases, and the production accuracy requirements are reduced. However, when the width of the first protruding segment 2221 is too large, sufficient soldering between the second ribbon B242 and the effective soldering position on the fourth cell piece 214A is affected, a current collection effect is reduced, and the bifaciality of the cell module is affected. In this embodiment, 1 mm $< d_1 \geq l_{41} + l_{42} + l_{43}$ is controlled to ensure that, on the basis of allowing the second insulation bar 222 to offset to a certain extent during preparation, the first protruding segment 2221 of the second insulation bar 222 can extend further to cover the edge region of the third cell piece 213A and the edge region of the fourth cell piece 214A, thereby further improving the reliability and production yield of the cell module, and reducing the production accuracy requirements. Moreover, sufficient soldering between the second ribbon B242 and the effective soldering position on the fourth cell piece 214A can be prevented from being affected, without resulting in unnecessary material waste and loss of the bifaciality.

Those skilled in the art can readily understand that, for the sake of convenience and brevity, the structure and implementation principles of the back contact cell described above can be referenced from the corresponding structure and implementation principles in the aforementioned Embodiment XI, Embodiment XII, and Embodiment XIII, and are not be described herein again.

Embodiment XV

Referring to Fig. 7, Fig. 9, and Fig. 19, this embodiment discloses a back contact cell module, including a cell string, a first insulation bar, a first bus bar, and a second ribbon A.

The cell string includes cell pieces serially connected to each other, where the cell pieces include a fifth cell piece 311 and a sixth cell piece 312, which are provided in a first direction; and the fifth cell piece 311 is provided on an end of the cell string.

The first insulation bar 321 is provided on an end of the sixth cell piece 312 close to the fifth cell piece 311.

The first bus bar 331 is provided on a side (i.e., a rear side of the first insulation bar 321, conversely, a side of the first insulation bar 321 facing toward the sixth cell piece 312 is a front side of the first insulation bar 321) of the first insulation bar 321 facing away from the sixth cell piece 312, wherein the first insulation bar 321 and the first bus bar 331 both extend in a second direction, and the first direction intersects the second direction.

The second ribbon A341 is configured to electrically connect the first bus bar 331 and the fifth cell piece 311.

An protruding segment 3211 extending outside the first bus bar 331 is provided on an end of the first insulation bar 321 close to the fifth cell piece 311, the protruding segment 3211 extends outside the sixth cell piece 312, and in a thickness direction of the sixth cell piece 312, an orthographic projection of the protruding segment 3211 is at least partially overlapped with an orthographic projection of the fifth cell piece 311. That is, the protruding segment 3211 can cover an edge region of the fifth cell piece 311, so as to separate the first bus bar 331 from the edge region of the fifth cell piece 311.

It can be understood that, an electrical connection mode can be soldering, bonding through a conductive adhesive, etc., but is not limited herein.

It can be understood that, in the cell string, the cell string can include two cell pieces connected in series, three cell pieces connected in series, or other higher number of cell pieces. The number of the cell pieces required to be connected in series can be determined according to actual use situations.

In this embodiment, the first bus bar 331 is an end bus bar, and the fifth cell piece 311 is located on the end of the cell string. For ease of description, in this embodiment, the end on which the fifth cell piece 311 is located is recorded as a tail end of the cell string. That is, in the first direction, the fifth cell piece 311 is the last cell piece of the cell string, and the sixth cell piece 312 is the penultimate cell piece of the cell string. It is not difficult to understand, the end on which the fifth cell piece 311 is located can also be recorded as a head end of the cell string, and details are not described herein again.

Optionally, in the same cell string, the adjacent cell pieces can be serially connected by means of soldering, the conductive adhesive, etc.

In an embodiment, the adjacent cell pieces are connected through series-connected ribbons 351. Specifically, the series-connected ribbons 351 include a first series-connected ribbon 3511 and a second series-connected ribbon 3512. In the first direction, the first series-connected ribbon 3511 and the second series-connected ribbon 3512 are provided in a staggered manner. In the second direction, the first series-connected ribbon 3511 and the second series-connected ribbon 3512 are provided in a staggered manner. In one cell string, Nth cell piece, (N+1)th cell piece, and (N+2)th cell piece (N is a positive integer greater than 1) are sequentially provided in the first direction. A anode solder joint of the Nth cell piece is serially connected to a cathode solder joint of the (N+1)th cell piece through a plurality of first series-connected ribbons 3511, and a anode solder joint of the (N+1)th cell piece is serially connected to a cathode solder joint of the (N+2)th cell piece through a plurality of second series-connected ribbons 3512.

During assembly, the cell pieces in the cell string are serially connected to each other. The first insulation bar 321 is provided on the end of the sixth cell piece 312 close to the fifth cell piece 311. The first bus bar 331 is provided on the rear side of the first insulation bar 321. A main body of the second ribbon A341 is electrically connected to an effective soldering position of the fifth cell piece 311. The end of the second ribbon A341 close to the sixth cell piece 312 is electrically connected to the first bus bar 331. Therefore, the first bus bar 331 can extract a current of the cell string.

First, in the embodiments of the present disclosure, the first bus bar 331 is provided on the sixth cell piece 312, and the first bus bar 331 is separated from the sixth cell piece 312 through the first insulation bar 321. In an aspect, a space for placing the bus bar does not need to be reserved in an edge of the cell module, the cell module can reserve more spaces to mount the cell pieces, such that the effective light-receiving area of the cell module is larger, and assembly conversion efficiency is higher. In another aspect, observing from the light-receiving surface (or referred to as "front side") of the cell piece, the first insulation bar 321 can cover the first bus bar 331 to prevent the first bus bar 331 from exposing, thereby making the entire cell module more aesthetic.

Furthermore, compared to a bus bar provided in an intermediate position of a rear side of the cell piece, the first bus bar 331 of this embodiment of the present disclosure is provided on the end of the sixth cell piece 312 close to the fifth cell piece 311, the second ribbon A341 can be fully attached to and soldered with an effective soldering position of the fifth cell piece 311, such that the insufficient soldering between the second ribbon A341 and the fifth cell piece 311 caused by the mounting of the first bus bar 331 is prevented from affecting collection of currents. Moreover, the second ribbon A341 can be directly connected to the first bus bar 331 after being soldered with the fifth cell piece 311, without perforating the insulation bar or replacing the insulation bar with insulation blocks provided intermittently. During assembly, the entire first insulation bar 321 only needs to be placed on the end of the sixth cell piece 312 close to the fifth cell piece 311, such that production accuracy requirements and production difficulty are effectively reduced, and position offset occurring when the insulation bar is perforated or position offset occurring during lamination of the insulation blocks can be avoided, thereby improving a product yield. Moreover, the first insulation bar 321 of the present disclosure is provided with the protruding segment 3211. In an aspect, the first insulation bar 321 is allowed to offset to a certain extent in the width direction relative to the first bus bar 331, as well as relative to two cell pieces, thereby reducing production accuracy requirements and production difficulty. In another aspect, the first insulation bar 321 can cover the edges of the sixth cell piece 312 and fifth cell piece 311, such that the risk of a short circuit caused by a contact between the first bus bar 331 and an shaped interconnect ribbon or asymmetric grid lines on the fifth cell piece 311 can be avoided, the risk of a short circuit caused by a contact between the second ribbon A341 and an shaped interconnect ribbon or asymmetric grid lines of the sixth cell piece 312 can also be avoided, and the risk of short circuits easily caused by conductive foreign matters such as tin residues during preparation can be avoided, thereby reducing the risk of short circuits, and improving the reliability of the cell module. In particular, when the cell piece is cut into half pieces, the cutting edge easily leads to a short circuit after cutting. The arrangement of the protruding segment 3211 of this embodiment of the present disclosure can effectively avoid the short circuit easily caused by the cutting edge, such that the reliability of the cell module can also be ensured by disposing the half cutting edge of the cell on the side on which the first bus bar 331 is located or on the side of the adjacent cell piece close to the first bus bar 331.

Furthermore, when the bus bar is provided on an outer edge, which is the end of the fifth cell piece 311 away from the sixth cell piece 312, of the last cell piece of the cell string, since the outer edge of the last cell piece of the cell string is close to an edge of the cell module, stress at the place is relatively large during lamination, easily leading to undesirable effects such as fragments. Moreover, the mounting of the bus bar affects the soldering between the second ribbon A341 and the fifth cell piece 311. In a position in which the bus bar is covered, the second ribbon A341 cannot be soldered with the fifth cell piece 311, leading to insufficient soldering between the second ribbon A341 and the fifth cell piece 311 and poor current collection, and this situation is particularly serious when the cell module is a back contact cell module without a Busbar.

Relatively speaking, the end bus bar in-built structure of this embodiment of the present disclosure can be suitable for a back contact cell module with a Busbar and the back contact cell module without the Busbar, and thus is stronger in universality. The end of the sixth cell piece 312 close to the fifth cell piece 311 has smaller stress during lamination compared to the outer edge of the last cell piece of the cell string, such that the risks of fragments and cracks can be reduced, thereby further improving the reliability of the cell module.

In an embodiment, referring to Fig. 7, Fig. 9, and Fig. 19, the fifth cell piece 311 and the sixth cell piece 312 are provided on the same plane. In the first direction, a width of a portion of the protruding segment 3211 extending outside the sixth cell piece 312 is greater than a space between the fifth cell piece 311 and the sixth cell piece 312.

Therefore, the protruding segment 3211 can be reserved with a sufficient width to allow the first insulation bar 321 to offset to a certain extent in the width direction relative to the first bus bar 331, as well as relative to two cell pieces, thereby reducing production accuracy requirements and production difficulty. In another aspect, the protruding segment 3211 can extend to cover the edge region of the fifth cell piece 311 and the edge region of the sixth cell piece 312, such that the risk of the short circuit caused by the contact between the first bus bar 331 and the shaped interconnect ribbon or asymmetric grid lines on the fifth cell piece 311 can be avoided, and the risk of the short circuit caused by the contact between the second ribbon A341 and the shaped interconnect ribbon or asymmetric grid lines of the sixth cell piece 312 can also be avoided, thereby further reducing the risk of short circuits, and improving the reliability of the cell module.

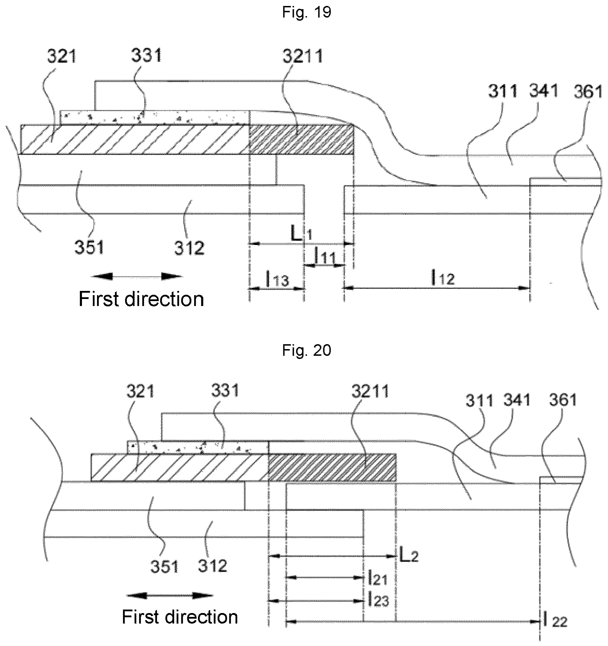

In some embodiments, referring to Fig. 19, in the first direction, the width of the protruding segment 3211 is as follows.

$$1 \text{ mm} \leq L_1 \leq l_{11} + l_{12} + l_{13}$$

In the formula, $L_1$ is the width of the protruding segment 3211 in the first direction; $l_{11}$ is the space between the fifth cell piece 311 and the sixth cell piece 312; $l_{12}$ is a relative width distance between an edge of the fifth cell piece 311 close to an end of the sixth cell piece 312 and a first solder joint 361; the first solder joint 361 is configured to be connected to the second ribbon A341, and is provided on the end of the fifth cell piece 311 close to the sixth cell piece 312; and $l_{13}$ is a relative width distance between an edge of the first bus bar 331 close to the end of the fifth cell piece 311 and the edge of the sixth cell piece 312 close to the end of the fifth cell piece 311.

It can be understood that, if $l_{11} + l_{13} > 1$ mm and $l_{11} < 1$ mm, $L_1 \geq 1$ mm is controlled, such that while it ensures that the protruding segment 3211 can extend to cover the edge region of the fifth cell piece 311 and the edge region of the sixth cell piece 312, sufficient offset spaces are reserved for the equipment leveling tolerance during preparation and the tolerance of bus bar offset during lamination. Therefore, the first insulation bar 321 can be allowed to offset slightly in the width direction relative to the first bus bar 331, as well as relative to two cell pieces.

When the width of the protruding segment 3211 is too small, the risk of short circuits is increased, and the reliability of the cell module is reduced. As the width of the protruding segment 3211 increases, the reliability of the cell module is improved, the allowed displacement deviation of the first insulation bar 321 during preparation in the width direction relative to the first bus bar 331, as well as relative to two cell pieces increases, and the production accuracy requirements are reduced. However, when the width of the protruding segment 3211 is too large, sufficient soldering between the second ribbon A341 and the effective soldering position on the fifth cell piece 311 is affected, a current collection effect is reduced, and the bifaciality of the cell module is affected. It can be understood that, the first solder joint 361 is located on the edge (i.e., the outermost connection point of the second ribbon A341 on the fifth cell piece 311) of the effective soldering position of the fifth cell piece 311 closest to the sixth cell piece 312. The first solder joint 361 can be a grid line or a bonding pad. In this embodiment of the present disclosure, $1\,mm \leq L_1 \leq l_{11}+l_{12}+l_{13}$ is controlled to ensure that the protruding segment 3211 of the first insulation bar 321 can extend to cover the edge region of the fifth cell piece 311 and the edge region of the sixth cell piece 312, thereby further improving the reliability and production yield of the cell module. Moreover, unnecessary material waste is not caused, and an impact on the sufficient soldering of the second ribbon A341 can be avoided.

In some embodiments, referring to Fig. 19, in the first direction, the width of the protruding segment 3211 is as follows.

$$1\,mm \leq L_1 \leq l_{11}+l_{13}+4\,mm$$

In the formula, $L_1$ is the width of the protruding segment 3211 in the first direction; $l_{11}$ is the space between the fifth cell piece 311 and the sixth cell piece 312; $l_{13}$ is the relative width distance between the edge of the first bus bar 331 close to the end of the fifth cell piece 311 and the edge of the sixth cell piece 312 close to the end of the fifth cell piece 311.

Within this range, on the basis of allowing offset errors during preparation, it still ensures that the protruding segment 3211 of the first insulation bar 321 can extend to cover the edge region of the fifth cell piece 311 and the edge region of the sixth cell piece 312, thereby further improving the reliability and production yield of the cell module. Moreover, unnecessary material waste is not caused, and it can also ensure that the sufficient soldering of the second ribbon A341 is not affected even if the first insulation bar 321 offsets during production preparation, such that the production accuracy can be effectively reduced.

In an embodiment, referring to Fig. 7 and Fig. 10, the cell module includes at least one series-connected cell string group 3100. The same series-connected cell string group 3100 includes two cell strings that are provided in the second direction and serially connected to each other; and the same series-connected cell string group 3100 extends from the sixth cell piece 312 in one cell string to the sixth cell piece 312 of the other cell string through the same first bus bar 331.

Optionally, the second ribbon A341 includes a first anode ribbon 3411 and a first cathode ribbon 3412. The same first bus bar 331 is electrically connected to the first anode ribbon 3411 in one cell string and is electrically connected to the first cathode ribbon 3412 in the other cell string, so as to form a serial connection between the adjacent cell pieces.

Exemplarily, the same series-connected cell string group 3100 includes a first cell string 310A and a second cell string 310B. The second ribbon A341 includes the first anode ribbon 3411 and the first cathode ribbon 3412. In the same series-connected cell string group 3100, the same first bus bar 331 extends from the sixth cell piece 312 in the first cell string 310A to the sixth cell piece 312 in the second cell string 310B. Moreover, in the first cell string 310A, the first bus bar 331 is electrically connected to the first anode ribbon 3411 on the fifth cell piece 311, and in the second cell string 310B, the first bus bar 331 is electrically connected to the first cathode ribbon 3412 on the fifth cell piece 311.

In an embodiment, the cell module includes a parallel-connected cell string group 3200. the same parallel-connected cell string group 3200 includes at least two cell strings that are provided in a first direction and parallelly connected to each other, and a spacing region is provided between two cell strings parallelly connected to each other. An intermediate bus bar 332 is provided in the spacing region. The intermediate bus bar 332 is configured to parallelly connect two cell strings adjacent to each other in the first direction, that is, the end bus bar in-built structure of this embodiment of the present disclosure can be mated with a mounting structure of a conventional intermediate bus bar 332.

In another embodiment, referring to Fig. 10 and Fig. 11, a fourth cell piece 314 is provided on an end of each cell string away from the fifth cell piece 311, and a third cell piece 313 is provided on an end of the fourth cell piece 314 close to the fifth cell piece 311. The cell module includes a parallel-connected cell string group 3200, wherein the same parallel-connected cell string group 3200 includes at least two cell strings that are provided in the first direction and parallelly connected to each other, and the fourth cell pieces 314 in the two parallel-connected cell strings are adjacent to each other in the first direction.

The cell module further includes a second insulation bar, an intermediate bus bar, and a second ribbon B.

The second insulation bar 322 is provided on an edge of the third cell piece 313 in one cell string and provided on an end of the third cell piece 313 close to the fourth cell piece 314.

The intermediate bus bar 332 is configured to parallelly connect two cell strings, which are adjacent to each other in the first direction. The intermediate bus bar 332 is provided on a side of the second insulation bar 322 facing away from the third cell piece 313.

The second insulation bar 322 and the intermediate bus bar 332 both extend in the second direction.

The second ribbon B342 is configured to electrically connect the intermediate bus bar 332, the fourth cell piece 314 in the cell string, and the fourth cell piece 314 in another cell string adjacent to the cell string in the first direction.

Exemplarily, referring to Fig. 10 and Fig. 11, for ease of description, the third cell string 320A and the fourth cell string 320B parallelly connected to each other in the same parallel-connected cell string group 3200 are used as an example. The third cell string 320A is the cell string in which the intermediate bus bar 332 is located.

The third cell piece 313 in the third cell string 320A is recorded as the third cell piece 313A, and the fourth cell piece 314 is recorded as the fourth cell piece 314A; the third cell piece 313 in the fourth cell string 320B is recorded as the third cell piece 313B, and the fourth cell piece 314 is recorded as the fourth cell piece 314B; the third cell string 320A and the fourth cell string 320B are provided in the first direction; and the fourth cell piece 314A and the fourth cell piece 314B are adjacent to each other in the first direction.

The cell module further includes the second insulation bar, the intermediate bus bar, and the second ribbon B.

The second insulation bar 322 is provided on an edge of the third cell piece 313A in the third cell string 320A and provided on an end of the third cell piece 313A close to the fourth cell piece 314A.

The intermediate bus bar 332 is configured to parallelly connect the third cell string 320A and the fourth cell string 320B. The intermediate bus bar 332 is provided on a side of the second insulation bar 322 facing away from the third cell piece 313.

The second insulation bar 322 and the intermediate bus bar 332 both extend in the second direction.

The second ribbon B342 is configured to electrically connect the intermediate bus bar 332, the fourth cell piece 314A, and the fourth cell piece 314B, that is, the same second ribbon B342 sequentially extends from the fourth cell piece 314B to the fourth cell piece 314A and the intermediate bus bar 332.

Optionally, the second ribbon B342 includes a second anode ribbon3421 and a second cathode ribbon 3422. The fourth cell piece 314A, the fourth cell piece 314B, and the intermediate bus bar 332 are electrically connected through the second anode ribbon 3421 and the second cathode ribbon 3422.

Through the intermediate bus bar 332 in-built structure of the present disclosure, in an aspect, an effective light-receiving area of the cell module can be increased, assembly conversion efficiency is improved, and the intermediate bus bar 332 is prevented from being exposed, thus making the entire cell module more aesthetic. In another aspect, it can ensure that the second ribbon B342 can be fully attached to and soldered with an effective soldering position of the fourth cell piece 314, such that the insufficient soldering between the second ribbon B342 and the fourth cell piece 314 caused by the arrangement of the intermediate bus bar 332 is prevented from affecting collection of currents. During assembly, the entire second insulation bar 322 only needs to be placed on the end of the third cell piece 313 close to the fourth cell piece 314. Moreover, through the arrangement of the extended portion 3221, during preparation, the second insulation bar 322 can be allowed to offset to a certain extent in the width direction relative to the intermediate bus bar 332, as well as relative to two cell pieces, such that production accuracy requirements and production difficulty are effectively reduced, and the risks of short circuits can be effectively reduced. Furthermore, the intermediate bus bar 332 in-built structure of this embodiment of the present disclosure can be suitable for the back contact cell module with the Busbar and the back contact cell module without the Busbar, and thus is stronger in universality. The intermediate bus bar 332 in-built structure has smaller stress during lamination, such that the risks of hidden cracks and fragments of the cell piece can be reduced, thereby achieving the good reliability of the back contact cell module.

The end bus bar in-built structure of this embodiment of the present disclosure is mated with the intermediate bus bar 332 in-built structure of this embodiment of the present disclosure, such that the effective light-receiving area of the cell module can be increased, the assembly conversion efficiency is improved, the aesthetics and reliability of the entire cell module are better, and the production accuracy requirements and production difficulty are effectively reduced, thereby improving production efficiency.

**In** an embodiment, referring to Fig. 10 and Fig. 11, an extended portion 3221 extending outside the intermediate bus bar 332 is provided on an end of the second insulation bar 322 close to the fourth cell piece 314, and extends outside the third cell piece 313; and in a thickness direction of the third cell piece 313, an orthographic projection of the extended portion 3221 is at least partially overlapped with an orthographic projection of the fourth cell piece 314 in the cell string in which the extended portion is located.

That is, the extended portion 3221 extending outside the intermediate bus bar 332 is provided on the end of the second insulation bar 322 close to the fourth cell piece 314A, and extends outside the third cell piece 313A; and in the thickness direction of the third cell piece 313A, the orthographic projection of the extended portion 3221 is at least partially overlapped with the orthographic projection of the fourth cell piece 314A.

The second insulation bar 322 of this embodiment of the present disclosure is provided with the protruding segment 3221. In an aspect, the second insulation bar 322 is allowed to offset to a certain extent in the width direction relative to the intermediate bus bar 332, as well as relative to two cell pieces, thereby reducing production accuracy requirements and production difficulty. In another aspect, the second insulation bar 322 can cover the edges of the third cell piece 313A and fourth cell piece 314A, such that the risk of a short circuit caused by a contact between the intermediate bus bar 332 and an shaped interconnect ribbon or asymmetric grid lines on the fourth cell piece 314 can be avoided, and the risk of a short circuit caused by a contact between the second ribbon B342 and an shaped interconnect ribbon or asymmetric grid lines of the third cell piece 313 can also be avoided, thereby further reducing the risk of short circuits, and improving the reliability of the cell module. In particular, when the cell piece is cut into half pieces, the cutting edge easily leads to a short circuit after cutting. The arrangement of the extended portion 3221 of this embodiment of the present disclosure can effectively avoid the short circuit easily caused by the cutting edge, such that the reliability of the cell module can also be ensured by disposing the half cutting edge of the cell on the side on which the intermediate bus bar 332 is located or on the side of the adjacent cell piece close to the intermediate bus bar 332.

Moreover, this embodiment of the present disclosure provides a photovoltaic system, including the above back contact cell module.

In this embodiment, the photovoltaic system can be applied to a photovoltaic power station such as a surface power station, a rooftop power station, a water surface power station, etc., or can also be applied to a device or an apparatus that uses solar energy for power generation, such as a user solar power supply, a solar street lamp, a solar car, a solar building, etc. Definitely, it can be understood that, the application scenarios of the photovoltaic system are not limited thereto, that is, the photovoltaic system can be used in all fields where solar energy is required for power generation. By using a photovoltaic power generation system network as an example, the photovoltaic system can include a photovoltaic array, a combiner box, and an inverter. The photovoltaic array can be an array combination of a plurality of cell assemblies. For example, the plurality of cell assemblies can constitute a plurality of photovoltaic arrays. The photovoltaic array is connected to the combiner box. The combiner box can converge currents generated by the photovoltaic array, and the converged currents are converted into alternating currents required by the municipal power grid by passing through the inverter, and then are connected to the municipal power network, so as to realize solar power supply.

Embodiment XVI

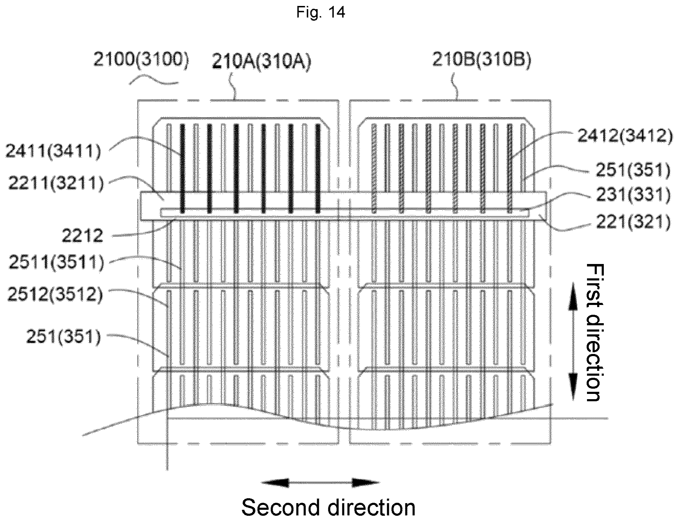

A difference between this embodiment and Embodiment XV lies in that, referring to Fig. 14, Fig. 20, and Fig. 21, the end of the sixth cell piece 312 close to the fifth cell piece 311 is at least partially stacked with the fifth cell piece 311.

In the first direction, a width of the protruding segment 3211 is greater than a width of a stacking region between the fifth cell piece 311 and the sixth cell piece 312.

That is, the fifth cell piece 311 and the sixth cell piece 312 are arranged in a shingled configuration, and there is no gap between the two cell pieces.

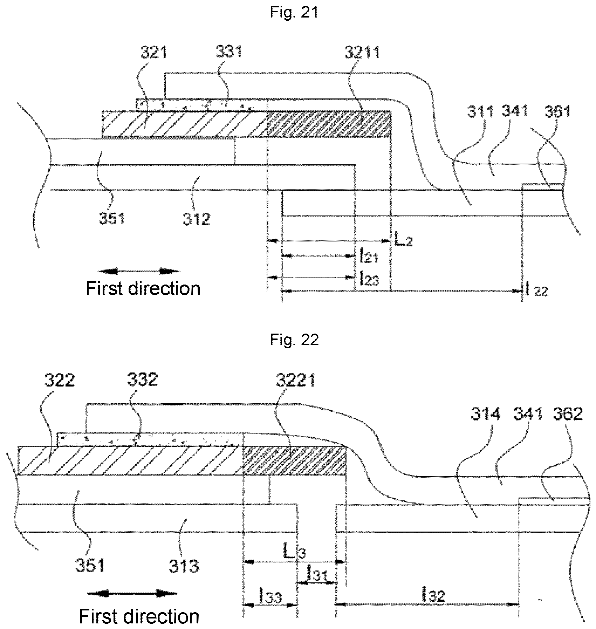

In an embodiment, referring to Fig. 21, the side of the sixth cell piece 312 facing away from the first insulation bar 321 is at least partially stacked with the fifth cell piece 311.

In another embodiment, referring to Fig. 20, the side of the sixth cell piece 312 facing toward the first insulation bar 321 is at least partially stacked with the fifth cell piece 311.

In an embodiment, optionally, the width of the protruding segment 3211 is as follows.

$$1 \text{ mm} \leq L_2 \leq I_{22} + I_{23} - I_{21}$$

In the formula, $L_2$ is the width of the protruding segment 3211 in the first direction; $I_{21}$ is the width of the stacking region between the fifth cell piece 311 and the sixth cell piece 312; $I_{22}$ is a relative width distance between an edge of the fifth cell piece 311 close to an end of the sixth cell piece 312 and a first solder joint 361; the first solder joint 361 is configured to be connected to the second ribbon A341, and is provided on the end of the fifth cell piece 311 close to the sixth cell piece 312; and $I_{23}$ is a relative width distance between an edge of the first bus bar 331 close to the end of the fifth cell piece 311 and the edge of the sixth cell piece 312 close to the end of the fifth cell piece 311.

It can be understood that, if $I_{21} + I_{23} > 1$ mm and $I_{21} < 1$ mm, $L_2 \geq 1$ mm is controlled, such that while it ensures that the protruding segment 3211 can extend to cover the edge region of the fifth cell piece 311 and the edge region of the sixth cell piece 312, sufficient offset spaces are reserved for the equipment leveling tolerance during preparation and the tolerance of bus bar offset during lamination. Therefore, the first insulation bar 321 can be allowed to offset slightly in the width direction relative to the first bus bar 331 during preparation.

When the width of the protruding segment 3211 is too small, the risk of short circuits is increased, and the reliability of the cell module is reduced. As the width of the protruding segment 3211 increases, the reliability of the cell module is improved, the allowed displacement deviation of the first insulation bar 321 during preparation in the width direction relative to the first bus bar 331, as well as relative to two cell pieces increases, and the production accuracy requirements are reduced. However, when the width of the protruding segment 3211 is too large, sufficient soldering between the second ribbon A341 and the effective soldering position on the fifth cell piece 311 is affected, a current collection effect is reduced, and the bifaciality of the cell module is affected. In this embodiment of the present disclosure, $1 \text{ mm} \leq L_2 \leq I_{22} + I_{23} - I_{21}$ is controlled to ensure that the protruding segment 3211 of the first insulation bar 321 can extend to cover the edge region of the fifth cell piece 311 and the edge region of the sixth cell piece 312, thereby further improving the reliability and production yield of the cell module. Moreover, unnecessary material waste is not caused, and an impact on the sufficient soldering of the second ribbon A341 can be avoided.

In an embodiment, optionally, the width of the protruding segment 3211 is as follows.

$$1 \text{ mm} \leq L_2 \leq l_{23} + 4 \text{ mm} - l_{21}$$

In the formula, $L_2$ is the width of the protruding segment 3211 in the first direction; $l_{21}$ is the width of the stacking region between the fifth cell piece 311 and the sixth cell piece 312; $l_{23}$ is the relative width distance between the edge of the first bus bar 331 close to the end of the fifth cell piece 311 and the edge of the sixth cell piece 312 close to the end of the fifth cell piece 311.

Within this range, on the basis of allowing offset errors during preparation, it still ensures that the protruding segment 3211 of the first insulation bar 321 can extend to cover the edge region of the fifth cell piece 311 and the edge region of the sixth cell piece 312, thereby further improving the reliability and production yield of the cell module. Moreover, unnecessary material waste is not caused, and it can also ensure that the sufficient soldering of the second ribbon A341 is not affected even if the first insulation bar 321 offsets during production preparation, such that the production accuracy can be effectively reduced.

Those skilled in the art can readily understand that, for the sake of convenience and brevity, the structure and implementation principles of the back contact cell described above can be referenced from the corresponding structure and implementation principles in the aforementioned Embodiment XVII, and are not be described herein again.

Embodiment XVII

Referring to Fig. 11 to Fig. 22, this embodiment discloses a back contact cell module, including a parallel-connected cell string group, a second insulation bar, an intermediate bus bar, and a second ribbon B.

The same parallel-connected cell string group 3200 includes at least two cell strings that are provided in a first direction and parallelly connected to each other, each cell string includes cell pieces serially connected to each other, the cell pieces include a third cell piece 313 and a fourth cell piece 314 provided in the first direction, the fourth cell piece 314 is provided on an end of the cell string, and the fourth cell pieces 314 in the two parallel-connected cell strings are adjacent to each other in the first direction.

The second insulation bar 322 is provided on an edge of the third cell piece 313 in one cell string and provided on an end of the third cell piece 313 close to the fourth cell piece 314.

The intermediate bus bar 332 is configured to parallelly connect two cell strings, which are adjacent to each other in the first direction. The intermediate bus bar 332 is provided on a side of the second insulation bar 322 facing away from the third cell piece 313.

The second insulation bar 322 and the intermediate bus bar 332 both extend in the second direction.

The second ribbon B342 is configured to electrically connect the intermediate bus bar 332, the fourth cell piece 314 in the cell string in which the intermediate bus bar 332 is located, and the fourth cell piece 314 in another cell string adjacent to the cell string in the first direction.

An extended portion 3221 extending outside the intermediate bus bar 332 is provided on an end of the second insulation bar 322 close to the fourth cell piece 314, and extends outside the third cell piece 313; and in a thickness direction of the third cell piece 313, an orthographic projection of the extended portion 3221 is at least partially overlapped with an orthographic projection of the fourth cell piece 314 in the cell string in which the extended portion is located.

Exemplarily, for ease of description, the third cell string 320A and the fourth cell string 320B parallelly connected to each other in the same parallel-connected cell string group 3200 are used as an example. The third cell string 320A is the cell string in which the intermediate bus bar 332 is located.

The third cell piece 313 in the third cell string 320A is recorded as the third cell piece 313A, and the fourth cell piece 314 is recorded as the fourth cell piece 314A; the third cell piece 313 in the fourth cell string 320B is recorded as the third cell piece 313B, and the fourth cell piece 314 is recorded as the fourth cell piece 314B; the third cell string 320A and the fourth cell string 320B are provided in the first direction; and the fourth cell piece 314A and the fourth cell piece 314B are adjacent to each other in the first direction.

The cell module further includes the second insulation bar, the intermediate bus bar, and the second ribbon B.

The second insulation bar 322 is provided on an edge of the third cell piece 313A in the third cell string 320A and provided on an end of the third cell piece 313A close to the fourth cell piece 314A.

The intermediate bus bar 332 is configured to parallelly connect the third cell string 320A and the fourth cell string 320B. The intermediate bus bar 332 is provided on a side of the second insulation bar 322 facing away from the third cell piece 313, and the second insulation bar 322 and the intermediate bus bar 332 both extend in the second direction.

The second ribbon B342 is configured to electrically connect the intermediate bus bar 332, the fourth cell piece 314A, and the fourth cell piece 314B, that is, the same second ribbon B342 sequentially extends from the fourth cell piece 314B to the fourth cell piece 314A and the intermediate bus bar 332.

An extended portion 3221 extending outside the intermediate bus bar 332 is provided on an end of the second insulation bar 322 close to the fourth cell piece 314A, and extends outside the third cell piece 313A; and in a thickness direction of the third cell piece 313A, an orthographic projection of the extended portion 3221 is at least partially overlapped with an orthographic projection of the fourth cell piece 314A.

During assembly, the cell pieces in the cell string are serially connected to each other. The second insulation bar 322 is provided on the end of the third cell piece 313A close to the fourth cell piece 314A. The intermediate bus bar 332 is provided on the rear side of the second insulation bar 322. A main body of the second ribbon B342 is electrically connected to an effective soldering position of the fourth cell piece 314A and an effective soldering position of the fourth cell piece 314B, respectively. The end of the second ribbon B342 close to the third cell piece 313A is electrically connected to the intermediate bus bar 332. Therefore, the intermediate bus bar 332 can be parallelly connected to the third cell string 320A and the fourth cell string 320B.

First, in this embodiment of the present disclosure, the intermediate bus bar 332 is provided on the third cell piece 313A, and the intermediate bus bar 332 is separated from the third cell piece 313Athrough the second insulation bar 322. **In** an aspect, a space for placing the bus bar does not need to be reserved in an edge of the cell module, the cell module can reserve more spaces to mount the cell pieces, such that the effective light-receiving area of the cell module is larger, and assembly conversion efficiency is higher. In another aspect, observing from the light-receiving surface (or referred to as "front side") of the cell piece, the second insulation bar 322 can cover the intermediate bus bar 332 to prevent the intermediate bus bar 332 from exposing, thereby making the entire cell module more aesthetic.

Then, compared to a bus bar provided in an intermediate position of a rear side of the cell piece, the intermediate bus bar 332 of this embodiment of the present disclosure is provided on the end of the third cell piece 313A close to the fourth cell piece 314A, the second ribbon B342 extends to the fourth cell piece 314A after being connected to the effective soldering position of the fourth cell piece 314B, and can be fully attached to and soldered with the effective soldering position of the fourth cell piece 314A, such that the insufficient soldering between the second ribbon B342 and the fourth cell piece 314A caused by the mounting of the intermediate bus bar 332 is prevented from affecting collection of currents. Moreover, the second ribbon B342 can be directly connected to the intermediate bus bar 332 after being soldered with the fourth cell piece 314A and the fourth cell piece 314B, without perforating the insulation bar or replacing the insulation bar with insulation blocks provided intermittently. During assembly, the entire second insulation bar 322 only needs to be placed on the end of the third cell piece 313A close to the fourth cell piece 314A, such that production accuracy requirements and production difficulty are effectively reduced, and position offset occurring when the insulation bar is perforated or position offset occurring during lamination of the insulation blocks can be avoided, thereby improving a product yield. Moreover, the second insulation bar 322 of this embodiment of the present disclosure is provided with the protruding segment 3221. **In** an aspect, the second insulation bar 322 is allowed to offset to a certain extent in the width direction relative to the intermediate bus bar 332, as well as relative to two cell pieces, thereby reducing production accuracy requirements and production difficulty. In another aspect, the second insulation bar 322 can cover the edges of the third cell piece 313A and fourth cell piece 314A, such that the risk of a short circuit caused by a contact between the intermediate bus bar 332 and an shaped interconnect ribbon or asymmetric grid lines on the fourth cell piece 314 can be avoided, and the risk of a short circuit caused by a contact between the second ribbon B342 and an shaped interconnect ribbon or asymmetric grid lines of the third cell piece 313 can also be avoided, thereby further reducing the risk of short circuits, and improving the reliability of the cell module. In particular, when the cell piece is cut into half pieces, the cutting edge easily leads to a short circuit after cutting. The arrangement of the extended portion 3221 of this embodiment of the present disclosure can effectively avoid the short circuit easily caused by the cutting edge, such that the reliability of the cell module can also be ensured by disposing the half cutting edge of the cell on the side on which the intermediate bus bar 332 is located or on the side of the adjacent cell piece close to the intermediate bus bar 332.

Furthermore, when the bus bar is provided on an outer edge, which is the end of the fourth cell piece 314A away from the third cell piece 313A, of the last cell piece of the cell string, since the outer edge of the last cell piece of the cell string is laminated, stress at the place is relatively large, easily leading to undesirable effects such as fragments. Moreover, the mounting of the bus bar affects the soldering between the second ribbon B342 and the fourth cell piece 314A. **In** a position in which the bus bar is covered, the second ribbon B342 cannot be soldered with the fourth cell piece 314A, leading to insufficient soldering between the second ribbon B342 and the fourth cell piece 314A and poor current collection, and this situation is particularly serious when the cell module is a back contact cell module without a Busbar.

Relatively speaking, the intermediate bus bar in-built structure of this embodiment of the present disclosure can be suitable for a back contact cell module with a Busbar and the back contact cell module without the Busbar, and thus is stronger in universality. Moreover, in an aspect, the end of the third cell piece 313A close to the fourth cell piece 314A has smaller stress during lamination compared to the outer edge of the last cell piece of the cell string, such that the risks of hidden cracks and fragments can be further reduced, thereby further improving the reliability of the back contact cell module.

In an embodiment, referring to Fig. 22, in the cell string in which the second insulation bar 322 is provided, the fourth cell piece 314 and the third cell piece 313 are provided on the same plane. In the first direction, a width of a portion of the extended portion 3221 extending outside the third cell piece 313 is greater than a space between the fourth cell piece 314 and the third cell piece 313.

Therefore, the extended portion 3221 can be reserved with a sufficient width to allow the second insulation bar 322 to offset to a certain extent in the width direction relative to the intermediate bus bar 332, as well as relative to two cell pieces during preparation, thereby reducing production accuracy requirements and production difficulty. In another aspect, the extended portion 3221 can extend to cover the edge region of the fourth cell piece 314A and the edge region of the third cell piece 313A, such that the risk of a short circuit caused by a contact between the intermediate bus bar 332 and an shaped interconnect ribbon or asymmetric grid lines on the fourth cell piece 314A can be avoided, and the risk of a short circuit caused by a contact between the second ribbon B342 and an shaped interconnect ribbon or asymmetric grid lines of the third cell piece 313A can also be avoided, thereby further reducing the risk of short circuits, and improving the reliability of the cell module.

In an embodiment, referring to Fig. 22, in the first direction, the width of the extended portion 3221 is as follows.

$$1 \text{ mm} \leq L_3 \leq l_{31} + l_{32} + l_{33}$$

In the formula, $L_3$ is the width of the extended portion 3221 in the first direction; $l_{31}$ is, in the cell string in which the second insulation bar 322 is provided, a space between the fourth cell piece 314 and the third cell piece 313; $l_{32}$ is, in the cell string in which the second insulation bar 322 is provided, a relative width distance between an edge of the fourth cell piece 314 close to an end of the third cell piece 313 and a second solder joint 362; and $l_{33}$ is, in the cell string in which the second insulation bar 322 is provided, a relative width distance between an edge of the intermediate bus bar 332 close to the end of the fourth cell piece 314 and the edge of the third cell piece 313 close to the end of the fourth cell piece 314.

It can be understood that, if $l_{31} + l_{33} > 1$ mm and $l_{31} < 1$ mm, $L_3 \geq 1$ mm is controlled, such that while it ensures that the extended portion 3221 can extend to cover the edge region of the fourth cell piece 314A and the edge region of the third cell piece 313A, sufficient offset spaces can be reserved for the equipment leveling tolerance during preparation and the laminated offset tolerance of the led-out holes of the bus bar. Therefore, the second insulation bar 322 can be allowed to offset slightly in the width direction relative to the intermediate bus bar 332, as well as relative to two cell pieces.

When the width of the extended portion 3221 is too small, the risk of short circuits is increased, and the reliability of the cell module is reduced. As the width of the extended portion 3221 increases, the reliability of the cell module is improved, the allowed displacement deviation of the second insulation bar 322 during preparation in the width direction relative to the intermediate bus bar 332, as well as relative to two cell pieces increases, and the production accuracy requirements are reduced. However, when the width of the extended portion 3221 is too large, sufficient soldering between the second ribbon B342 and the effective soldering position on the fourth cell piece 314A is affected, a current collection effect is reduced, and the bifaciality of the cell module is affected. It can be understood that, the second solder joint 362 is located on the edge (i.e., the outermost connection point of the second ribbon B342 on the third cell piece 313A) of the effective soldering position of the fourth cell piece 314A closest to the third cell piece 313A. The second solder joint 362 can be a grid line or a bonding pad. In this embodiment of the present disclosure, by controlling $1 \text{ mm} \leq L_3 \leq l_{31} + l_{32} + l_{33}$, on the basis of allowing offset errors during preparation, it still can ensure that the extended portion 3221 of the second insulation bar 322 can extend to cover the edge region of the fourth cell piece 314A and the edge region of the third cell piece 313A, thereby further improving the reliability and production yield of the cell module. Moreover, unnecessary material waste is not caused, and an impact on the sufficient soldering of the second ribbon B342 can be avoided.

In an embodiment, in the first direction, the width of the extended portion 3221 is as follows.

$$1 \text{ mm} \leq L_3 \leq l_{31} + l_{33} + 4 \text{ mm}$$

In the formula, $L_3$ is the width of the extended portion 3221 in the first direction; $l_{31}$ is, in the cell string in which the second insulation bar 322 is provided, a space between the fourth cell piece 314 and the third cell piece 313; and $l_{33}$ is, in the cell string in which the second insulation bar 322 is provided, the relative width distance between the edge of the intermediate bus bar 332 close to the end of the fourth cell piece 314 and the edge of the third cell piece 313 close to the end of the fourth cell piece 314.

Within this range, on the basis of allowing offset errors during preparation, it still ensures that the extended portion 3221 of the second insulation bar 322 can extend to cover the edge region of the fourth cell piece 314A and the edge region of the third cell piece 313A, thereby further improving the reliability and production yield of the cell module. Moreover, unnecessary material waste is not caused, and it can also ensure that the sufficient soldering of the second ribbon B is not affected even if the first insulation bar 321 offsets during production preparation, such that the production accuracy can be effectively reduced.

Those skilled in the art can readily understand that, for the sake of convenience and brevity, the structure and implementation principles of the back contact cell described above can be referenced from the corresponding structure and implementation principles in the aforementioned Embodiment XVII, and are not be described herein again.

Embodiment XVIII

A difference between this embodiment and Embodiment XVII lies in that, referring to Fig. 16, Fig. 23, and Fig. 24, in the cell string in which the second insulation bar 322 is provided, the end of the third cell piece 313 close to the fourth cell piece 314 is at least partially stacked with the fourth cell piece 314.

In the first direction, a width of the extended portion 3221 is greater than a width of a stacking region between the third cell piece 313 and the fourth cell piece 314.

That is, the third cell piece 313A and the fourth cell piece 314A are arranged in a shingled configuration, and there is no gap between the two cell pieces.

In an embodiment, the side of the third cell piece 313A facing away from the second insulation bar 322 is at least partially stacked with the fourth cell piece 314A.

In another embodiment, the side of the third cell piece 313A facing toward the first insulation bar 321 is at least partially stacked with the fourth cell piece 314A.

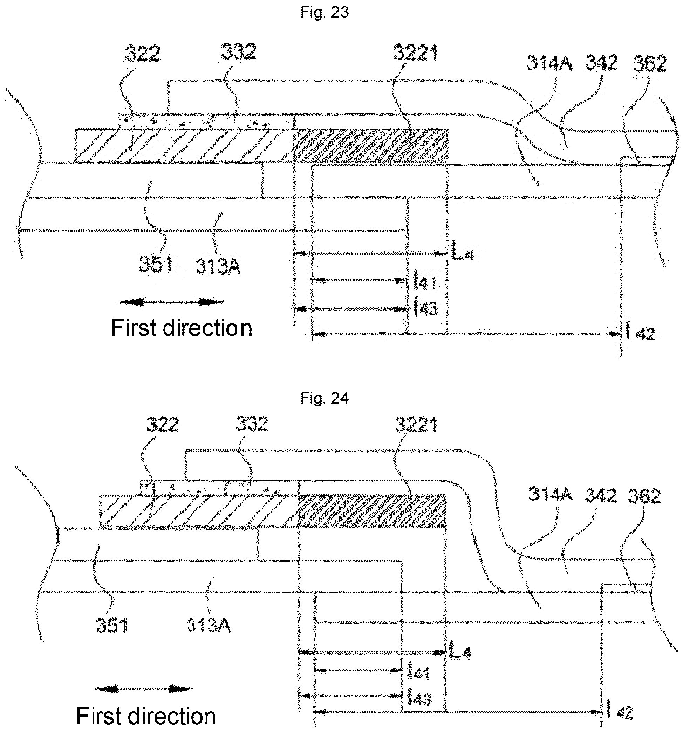

In an embodiment, referring to Fig. 23 and Fig. 24, in the first direction, the width of the extended portion 3221 is as follows.

$$1 \text{ mm} \leq L_4 \leq l_{42} + l_{43} - l_{41}$$

**In the formula,** $L_4$ is the width of the extended portion 3221 in the first direction; $l_{41}$ is the width of a stacking region between the third cell piece 313 and the fourth cell piece 314; $l_{42}$ is, in the cell string in which the second insulation bar 322 is provided, a relative width distance between an edge of the fourth cell piece 314 close to an end of the third cell piece 313 and a second solder joint 362; and $l_{43}$ is, in the cell string in which the second insulation bar 322 is provided, a relative width distance between an edge of the intermediate bus bar 332 close to the end of the fourth cell piece 314 and the edge of the third cell piece 313 close to the end of the fourth cell piece 314.

**It** can be understood that, if $l_{41} + l_{43} > 1$ mm and $l_{41} < 1$ mm, $L_4 \geq 1$ mm is controlled, such that while it ensures that the extended portion 3221 can extend to cover the edge region of the fourth cell piece 314A and the edge region of the third cell piece 313A, sufficient offset spaces can be reserved for the equipment leveling tolerance during preparation and the laminated offset tolerance of the led-out holes of the bus bar. Therefore, the second insulation bar 322 can be allowed to offset slightly in the width direction relative to the intermediate bus bar 332, as well as relative to two cell pieces.

In an embodiment, referring to Fig. 23 and Fig. 24, in the first direction, the width of the extended portion 3221 is as follows.

$$1 \text{ mm} \leq L_4 \leq l_{43} - l_{41} + 4 \text{ mm}$$

In the formula, $L_4$ is the width of the extended portion 3221 in the first direction; $l_{41}$ is the width of a stacking region between the third cell piece 313 and the fourth cell piece 314; $l_{42}$ is, in the cell string in which the second insulation bar 322 is provided, a relative width distance between an edge of the fourth cell piece 314 close to an end of the third cell piece 313 and a second solder joint 362; and $l_{43}$ is, in the cell string in which the second insulation bar 322 is provided, a relative width distance between an edge of the intermediate bus bar 332 close to the end of the fourth cell piece 314 and the edge of the third cell piece 313 close to the end of the fourth cell piece 314.

In the description of the specification, descriptions of the terms "some embodiments," "exemplary", "example," or "for example", mean that specific features, structures, materials, or characteristics described with reference to the implementations or examples are included in at least one implementation or example of the present disclosure. In this specification, schematic representations of the above terms do not necessarily refer to the same embodiment or example. In addition, the described particular features, structures, materials or characteristics can be combined in any suitable manner in any one or more embodiments or examples.

The foregoing are merely preferred embodiments of the present disclosure and are not a limitation of the present disclosure in any form. Although the present disclosure has been disclosed as above according to the preferred embodiments, however, it is not used to limit the present disclosure. Any person skilled in the art of the present patent can use the technical content of the above hints to make some changes or modifications to equivalent embodiments without departing from the scope of the technical solution of the present disclosure, but the content without departing from the technical solutions of the present disclosure, and any simple modifications, equivalent changes and modifications to the above embodiments on the basis of the technical substance of the present disclosure all still fall within the scope of the present disclosure.

**Claims**

1. A back contact cell module, comprising:

   a cell string, comprising a plurality of cell pieces in series connection, wherein the plurality of cell pieces are provided along a first direction;
   an insulation bar, provided on a backlight surface of the cell piece along a second direction, wherein the first direction intersects the second direction; and
a bus bar, provided on a side of the insulation bar facing away from the cell piece along the second direction, wherein the insulation bar covers a surface of a side of the bus bar close to the cell piece;
wherein the cell string comprises a first cell piece and a second cell piece, which are adjacent to each other; the insulation bar is provided on a backlight surface of the first cell piece; a second ribbon is connected to the second cell piece and the bus bar, respectively; and the insulation bar blocks the second ribbon and the first cell piece.

2. The back contact cell module according to claim 1, wherein the insulation bar covers the bus bar in the second direction, and the insulation bar covers and exceeds the bus bar in the first direction.

3. The back contact cell module according to claim 1, further comprising a ribbon, wherein the ribbon comprises a first ribbon and the second ribbon, the first ribbon is configured to connect adjacent cell pieces, and the second ribbon is configured to connect the cell piece and the bus bar.

4. The back contact cell module according to claim 3, wherein the second ribbon is provided on a side of the bus bar away from the insulation bar or the second ribbon is provided on a side of the bus bar close to the insulation bar.

5. The back contact cell module according to claim 1, wherein the first cell piece and the second cell piece are at least partially stacked together.

6. The back contact cell module according to claim 5, wherein, when the backlight surface of the first cell piece and a light-receiving surface of the second cell piece are at least partially stacked together, the insulation bar is at least partially connected to a backlight surface of the second cell piece.

7. The back contact cell module according to claim 1, wherein the cell piece is rectangular in shape; the cell piece further comprises a chamfer edge and a cutting edge; the chamfer edge and the cutting edge both are provided on two sides of the cell piece in the first direction; and the first direction is perpendicular to the second direction.

8. The back contact cell module according to claim 7, wherein in the first direction, the chamfer edge of one cell piece of two adjacent cell pieces abuts against the chamfer edge of an other cell piece of two adjacent cell piece, and the cutting edge of one cell piece of two adjacent cell pieces abuts against the cutting edge of an other cell piece of two adjacent cell pieces; or in the first direction, the chamfer edge of one cell piece of two adjacent cell pieces abuts against the cutting edge of an other cell piece of two adjacent cell pieces, and the cutting edge of one cell piece of two adjacent cell pieces abuts against the chamfer edge of an other cell piece of two adjacent cell pieces.

9. The back contact cell module according to claim 8, wherein the chamfer edge of each of the cell pieces is stacked on the backlight surface of the side in which the cutting edge of the adjacent cell piece is located.

10. A back contact cell module, comprising:

a cell string, comprising cell pieces serially connected to each other, wherein the cell pieces comprise a fifth cell piece and a sixth cell piece, which are provided in a first direction;
a first insulation bar, provided on an end of the sixth cell piece close to the fifth cell piece;
a first bus bar, provided on a side of the first insulation bar facing away from the sixth cell piece, wherein the first insulation bar and the first bus bar both extend in a second direction, and the first direction intersects the second direction; and
a second ribbon A, configured to electrically connect the first bus bar and the fifth cell piece, wherein
in the first direction, a first widened section and a second widened section, which extend outside an edge of the first bus bar, are provided on two ends of the first insulation bar; the first widened section and the second widened section are provided in sequence in a direction away from the fifth cell piece; and a width of the second widened section is less than a width of the first widened section.

11. The back contact cell module according to claim 10, wherein at least a portion of the first widened section extends outside an edge of the sixth cell piece.

12. The back contact cell module according to claim 11, wherein in the first direction, an orthographic projection of the first widened section in a thickness direction of the sixth cell piece is at least partially overlapped with an orthographic projection of the fifth cell piece in the thickness direction of the sixth cell piece.

13. The back contact cell module according to claim 10, wherein in the first direction, the width of the second widened section is $D_2 \geq 1$ mm.

14. The back contact cell module according to claim 10, wherein the fifth cell piece and the sixth cell piece are provided on a same plane, wherein

$$1\ mm < D_1 \leq l_{11} + l_{12} + l_{13}$$

in the formula, $D_1$ is the width of the first widened section in the first direction, $l_{11}$ is, in the first direction, a relative width distance between the first bus bar and an edge of the sixth cell piece close to an end of the fifth cell piece, $l_{12}$ is a space between the fifth cell piece and the sixth cell piece, $l_{13}$ is a relative width distance between an edge of the fifth cell piece close to an end of the sixth cell piece and a first solder joint, and the first solder joint is provided on the end of the fifth cell piece close to the sixth cell piece, so as to be connected to the second ribbon A.

15. The back contact cell module according to claim 10, wherein the end of the sixth cell piece close to the fifth cell piece is at least partially stacked with the fifth cell piece, wherein

$$1\ mm < D_1 \leq l_{21} + l_{23} - l_{22}$$

in the formula, $D_1$ is the width of the first widened section in the first direction, $l_{21}$ is, in the first direction, a relative width distance between the first bus bar and the edge of the sixth cell piece close to an end of the fifth cell piece, $l_{22}$ is, in the first direction, a width of a stacking region between the fifth cell piece and the sixth cell piece, $l_{23}$ is a relative width distance between the edge of the fifth cell piece close to an end of the sixth cell piece and the first solder joint, and the first solder joint is provided on an end of the fifth cell piece close to the sixth cell piece, so as to be connected to the second ribbon A.

16. The back contact cell module according to claim 10, further comprising a front sheet, wherein the cell string is provided on the front sheet, the front sheet is provided with a first edge and a second edge in the second direction, and an orthographic projection of the first insulation bar in a thickness direction of the sixth cell piece falls between the first edge and the second edge.

17. The back contact cell module according to claim 10, wherein an orthographic projection of the first bus bar in a thickness direction of the sixth cell piece falls in the sixth cell piece.

18. The back contact cell module according to claim 10, wherein the back contact cell module comprises at least one series-connected cell string group, a same series-connected cell string group comprises two cell strings that are provided in the second direction and serially connected to each other; and the same series-connected cell string group extends from the sixth cell piece in one cell string to the sixth cell piece of an other cell string through a same first bus bar.

19. The back contact cell module according to claim 10, wherein a fourth cell piece is provided on an end of each cell string away from the fifth cell piece, and a third cell piece is provided on an end of the fourth cell piece close to the fifth cell piece; and
the back contact cell module further comprises:

a second insulation bar, provided on an edge of the third cell piece in one cell string and provided on an end of the third cell piece close to the fourth cell piece;
an intermediate bus bar, configured to parallelly connect two cell strings, which are adjacent to each other in the first direction, wherein the intermediate bus bar is provided on a side of the second insulation bar facing away from the third cell piece, and the second insulation bar and the intermediate bus bar both extend in the second direction; and
a second ribbon B, configured to electrically connect the intermediate bus bar, the fourth cell piece in the cell string, and the fourth cell piece in another cell string adjacent to the cell string in the first direction.

20. The back contact cell module according to claim 19, wherein, in the first direction, a first protruding segment and a second protruding segment, which extend outside an edge of the intermediate bus bar, are provided on two ends of the second insulation bar; the first protruding segment and the second protruding segment are provided in sequence in a direction away from the fourth cell piece; at least a portion of the first protruding segment extends outside an edge of the third cell piece; and a width of the second protruding segment is less than a width of the first protruding segment.

21. A back contact cell module, comprising:

a parallel-connected cell string group, wherein a same parallel-connected cell string group comprises at least two cell strings that are provided in a first direction and parallelly connected to each other, each cell string comprises cell pieces serially connected to each other, a series-connected cell pieces comprise a third cell piece and a fourth cell piece provided in the first direction, and the fourth cell pieces in two parallel-connected cell strings are adjacent to each other in the first direction;
a second insulation bar, provided on an edge of the third cell piece in one cell string and provided on an end of the third cell piece close to the fourth cell piece;

an intermediate bus bar, configured to parallelly connect two cell strings, which are adjacent to each other in the first direction, wherein the intermediate bus bar is provided on a side of the second insulation bar facing away from the third cell piece, and the second insulation bar and the intermediate bus bar both extend in the second direction; and

a second ribbon B, configured to electrically connect the intermediate bus bar, the fourth cell piece in the cell string in which the intermediate bus bar is located, and the fourth cell piece in another cell string adjacent to the cell string in the first direction, wherein

in the first direction, a first protruding segment and a second protruding segment, which extend outside an edge of the intermediate bus bar, are provided on two ends of the second insulation bar; the first protruding segment and the second protruding segment are provided in sequence in a direction away from the fourth cell piece; and a width of the second protruding segment is less than a width of the first protruding segment.

22. The back contact cell module according to claim 21, wherein at least a portion of the first protruding segment extends outside an edge of the third cell piece.

23. The back contact cell module according to claim 22, wherein in the first direction, an orthographic projection of the first protruding segment in a thickness direction of the third cell piece is at least partially overlapped with an orthographic projection of the fourth cell piece in the thickness direction of the third cell piece.

24. The back contact cell module according to claim 21, wherein in the first direction, the width of the second protruding segment is $d_2 \geq 1$ mm.

25. The back contact cell module according to claim 21, wherein the fourth cell piece and the third cell piece are provided on a same plane, wherein

$$1 \text{ mm} < d_1 \leq l_{31} + l_{32} + l_{33}$$

in the formula, $d_1$ is the width of the first protruding segment in the first direction; $l_{31}$ is, in the cell string in which the intermediate bus bar is provided, and in the first direction, a relative width distance between the intermediate bus bar and the edge of the third cell piece close to an end of the fourth cell piece; $l_{32}$ is, in the cell string in which the intermediate bus bar is provided, a space between the fourth cell piece and the third cell piece; $l_{33}$ is, in the cell string in which the intermediate bus bar is provided, a relative width distance between the edge of the fourth cell piece close to an end of the third cell piece and a second solder joint; and the second solder joint is provided on the fourth cell piece in the cell string in which the intermediate bus bar is provided, and is provided on an end of the fourth cell piece close to the third cell piece, so as to be connected to the second ribbon B.

26. The back contact cell module according to claim 21, wherein, in the cell string in which the intermediate bus bar is provided, the end of the third cell piece close to the fourth cell piece is at least partially stacked with the fourth cell piece, wherein

$$1 \text{ mm} < d_1 \leq l_{41} + l_{43} - l_{42}$$

in the formula, $d_1$ is the width of the first protruding segment in the first direction; $l_{41}$ is, in the cell string in which the intermediate bus bar is provided, and in the first direction, a relative width distance between the intermediate bus bar and the edge of the third cell piece close to an end of the fourth cell piece; $l_{a2}$ is, in the first direction, a width of a stacking region between the third cell piece and the fourth cell piece; $l_{43}$ is, in the cell string in which the intermediate bus bar is provided, a relative width distance between the edge of the fourth cell piece close to an end of the third cell piece and a second solder joint; and the second solder joint is provided on the end of the fourth cell piece close to the third cell piece, so as to be connected to the second ribbon B.

27. The back contact cell module according to claim 21, wherein the back contact cell module further comprises a front sheet, the cell string is provided on the front sheet, the front sheet is provided with a first edge and a second edge in the second direction, and an orthographic projection of the second insulation bar in a thickness direction of the third cell piece falls between the first edge and the second edge.

28. A back contact cell module, comprising:

a cell string, comprising cell pieces serially connected to each other, wherein the cell pieces comprise a fifth cell piece and a sixth cell piece, which are provided in a first direction;
a first insulation bar, provided on an end of the sixth cell piece close to the fifth cell piece;
a first bus bar, provided on a side of the first insulation bar facing away from the sixth cell piece, wherein the first insulation bar and the first bus bar both extend in a second direction, and the first direction intersects the second direction; and
a second ribbon A, configured to electrically connect the first bus bar and the fifth cell piece, wherein

an protruding segment extending outside the first bus bar is provided on an end of the first insulation bar close to the fifth cell piece, the protruding segment extends outside the sixth cell piece, and in a thickness direction of the sixth cell piece, an orthographic projection of the protruding segment is at least partially overlapped with an orthographic projection of the fifth cell piece.

29. The back contact cell module according to claim 28, wherein the fifth cell piece and the sixth cell piece are provided on a same plane; and
in the first direction, a width of a portion of the protruding segment extending outside the sixth cell piece is greater than a space between the fifth cell piece and the sixth cell piece.

30. The back contact cell module according to claim 29, wherein in the first direction, a width of the protruding segment is:

$$1 \text{ mm} \leq L_1 \leq l_{11}+l_{12}+l_{13}$$

in the formula, $L_1$ is the width of the protruding segment in the first direction; $l_{11}$ is the space between the fifth cell piece and the sixth cell piece; $l_{12}$ is a relative width distance between an edge of the fifth cell piece close to an end of the sixth cell piece and a first solder joint; the first solder joint is configured to be connected to the second ribbon A, and is provided on an end of the fifth cell piece close to the sixth cell piece; and $l_{13}$ is a relative width distance between an edge of the first bus bar close to the end of the fifth cell piece and an edge of the sixth cell piece close to the end of the fifth cell piece.

31. The back contact cell module according to claim 29, wherein in the first direction, the width of the protruding segment is:

$$1 \text{ mm} \leq L_1 \leq l_{11}+l_{13}+4 \text{ mm}$$

in the formula, $L_1$ is the width of the protruding segment in the first direction; $l_{11}$ is the space between the fifth cell piece and the sixth cell piece; $l_{13}$ is the relative width distance between the edge of the first bus bar close to the end of the fifth cell piece and the edge of the sixth cell piece close to the end of the fifth cell piece.

32. The back contact cell module according to claim 28, wherein the end of the sixth cell piece close to the fifth cell piece is at least partially stacked with the fifth cell piece;
in the first direction, a width of the protruding segment is greater than a width of a stacking region between the fifth cell piece and the sixth cell piece.

33. The back contact cell module according to claim 32, wherein the width of the protruding segment is:

$$1 \text{ mm} \leq L_2 \leq l_{22}+l_{23}-l_{21}$$

in the formula, $L_2$ is the width of the protruding segment in the first direction; $l_{21}$ is the width of the stacking region between the fifth cell piece and the sixth cell piece; $l_{22}$ is a relative width distance between an edge of the fifth cell piece close to an end of the sixth cell piece and a first solder joint; the first solder joint is configured to be connected to the second ribbon A, and is provided on the end of the fifth cell piece close to the sixth cell piece; and $l_{23}$ is a relative width distance between an edge of the first bus bar close to the end of the fifth cell piece and the edge of the sixth cell piece close to the end of the fifth cell piece.

34. The back contact cell module according to claim 32, wherein the width of the protruding segment is:

$$1 \text{ mm} \leq L_2 \leq l_{23}+4 \text{ mm}-l_{21}$$

in the formula, $L_2$ is the width of the protruding segment in the first direction; $l_{21}$ is the width of the stacking region between the fifth cell piece and the sixth cell piece; $l_{23}$ is the relative width distance between the edge of the first bus bar close to the end of the fifth cell piece and the edge of the sixth cell piece close to the end of the fifth cell piece.

35. The back contact cell module according to claim 28, comprising at least one series-connected cell string group, wherein a same series-connected cell string group comprises two cell strings that are provided in the second direction and serially connected to each other; and the same series-connected cell string group extends from the sixth cell piece in one cell string to the sixth cell piece of the other cell string through a same first bus bar.

36. The back contact cell module according to claim 28, wherein a fourth cell piece is provided on an end of each cell string away from the fifth cell piece, and a third cell piece is provided on an end of the fourth cell piece close to the fifth cell piece;

the cell module comprises a parallel-connected cell string group, wherein a same parallel-connected cell string group comprises at least two cell strings that are provided in the first direction and parallelly connected to each other, and the fourth cell pieces in two parallel-connected cell strings are adjacent to each other in the first direction; and
the back contact cell module further comprises:

a second insulation bar, provided on an edge of the third cell piece in one cell string and provided on an end of the third cell piece close to the fourth cell piece;
an intermediate bus bar, configured to parallelly connect two cell strings, which are adjacent to each other in the first direction, wherein the intermediate bus bar is provided on a side of the second insulation bar facing away from the third cell piece, and the second insulation bar and the intermediate bus bar both extend in the second direction; and
a second ribbon B, configured to electrically connect the intermediate bus bar, the fourth cell piece in the cell string, and the fourth cell piece in another cell string adjacent to the cell string in the first direction.

37. The back contact cell module according to claim 36, wherein an extended portion extending outside the intermediate bus bar is provided on an end of the second insulation bar close to the fourth cell piece, and extends outside the third cell piece; and in a thickness direction of the third cell piece, an orthographic projection of the extended portion is at least partially overlapped with an orthographic projection of the fourth cell piece in the cell string in which the extended portion is located.

38. A back contact cell module, comprising:

a parallel-connected cell string group, wherein a same parallel-connected cell string group comprises at least two cell strings that are provided in a first direction and parallelly connected to each other, each cell string comprises cell pieces serially connected to each other, the cell pieces comprise a third cell piece and a fourth cell piece provided in the first direction, and the fourth cell pieces in two parallel-connected cell strings are adjacent to each other in the first direction;
a second insulation bar, provided on an edge of the third cell piece in one cell string and provided on an end of the third cell piece close to the fourth cell piece;
an intermediate bus bar, configured to parallelly connect two cell strings, which are adjacent to each other in the first direction, wherein the intermediate bus bar is provided on a side of the second insulation bar facing away from the third cell piece, and the second insulation bar and the intermediate bus bar both extend in the second direction; and
a second ribbon B, configured to electrically connect the intermediate bus bar, the fourth cell piece in the cell string in which the intermediate bus bar is located, and the fourth cell piece in another cell string adjacent to the cell string in the first direction, wherein
an extended portion extending outside the intermediate bus bar is provided on an end of the second insulation bar close to the fourth cell piece, and extends outside the third cell piece; and in a thickness direction of the third cell piece, an orthographic projection of the extended portion is at least partially overlapped with an orthographic projection of the fourth cell piece in the cell string in which the extended portion is located.

39. The back contact cell module according to claim 38, wherein, in the cell string in which the second insulation bar is provided, the fourth cell piece and the third cell piece are provided on a same plane; and in the first direction, a width of a portion of the extended portion extending outside the third cell piece is greater than a space between the fourth cell piece and the third cell piece.

40. The back contact cell module according to claim 39, wherein in the first direction, a width of the extended portion is:

$$1\ mm \leq L_3 \leq l_{31} + l_{32} + l_{33}$$

in the formula, $L_3$ is the width of the extended portion in the first direction; $l_{31}$ is, in the cell string in which the second insulation bar is provided, a space between the fourth cell piece and the third cell piece; $l_{32}$ is, in the cell string in which the second insulation bar is provided, a relative width distance between an edge of the fourth cell piece close to an end of the third cell piece and a second solder joint; and $l_{33}$ is, in the cell string in which the second insulation bar is provided, a relative width distance between an edge of the intermediate bus bar close to the end of the fourth cell piece and the edge of the third cell piece close to the end of the fourth cell piece.

41. The back contact cell module according to claim 40, wherein in the first direction, the width of the extended portion is:

$$1\ mm \leq L_3 \leq l_{31} + l_{33} + 4\ mm$$

in the formula, $L_3$ is the width of the extended portion in the first direction; $l_{31}$ is, in the cell string in which the second insulation bar is provided, a space between the fourth cell piece and the third cell piece; and $l_{33}$ is, in the cell string in which the second insulation bar is provided, the relative width distance between the edge of the intermediate bus bar close to the end of the fourth cell piece and the edge of the third cell piece close to the end of the fourth cell piece.

42. The back contact cell module according to claim 38, wherein, in the cell string in which the second insulation bar is provided, the end of the third cell piece close to the fourth cell piece is at least partially stacked with the fourth cell piece; and
in the first direction, a width of the extended portion is greater than a width of a stacking region between the third cell piece and the fourth cell piece.

43. The back contact cell module according to claim 42, wherein in the first direction, the width of the extended portion is:

$$1 \text{ mm} \leq L_4 \leq l_{42} + l_{43} - l_{41}$$

in the formula, $L_4$ is the width of the extended portion in the first direction; $l_{41}$ is the width of a stacking region between the third cell piece and the fourth cell piece; $l_{42}$ is, in the cell string in which the second insulation bar is provided, a relative width distance between an edge of the fourth cell piece close to an end of the third cell piece and a second solder joint; and $l_{43}$ is, in the cell string in which the second insulation bar is provided, a relative width distance between an edge of the intermediate bus bar close to the end of the fourth cell piece and the edge of the third cell piece close to the end of the fourth cell piece.

44. The back contact cell module according to claim 42, wherein in the first direction, the width of the extended portion is:

$$1 \text{ mm} \leq L_4 \leq l_{43} - l_{41} + 4 \text{ mm}$$

in the formula, $L_4$ is the width of the extended portion in the first direction; $l_{41}$ is the width of a stacking region between the third cell piece and the fourth cell piece; $l_{42}$ is, in the cell string in which the second insulation bar is provided, a relative width distance between an edge of the fourth cell piece close to an end of the third cell piece and a second solder joint; and $l_{43}$ is, in the cell string in which the second insulation bar is provided, a relative width distance between an edge of the intermediate bus bar close to the end of the fourth cell piece and the edge of the third cell piece close to the end of the fourth cell piece.

45. A photovoltaic system, comprising the back contact cell module according to any one of claims 1 to 44.

Fig. 1

1100

1115

110

130

1111

111

120

1112

First direction

140

141

1113

142

1116

Second direction

Fig. 2

Fig. 3

Fig. 4

Fig. 5

1100

110

1111

1112

1115

1116

Second direction

First direction

Fig. 6

Fig. 7

Fig. 8

Fig. 9

Fig. 10

Fig. 11

Fig. 12

First direction

Fig. 13

First direction

Fig. 14

Fig. 15

First direction

Fig. 16

First direction

Second direction

Fig. 17

2222 222 232 2221 214A 242 262

$d_2$ 251 213A $d_1$ $l_{42}$ $l_{41}$ $l_{43}$

First direction

Fig. 18

2222 222 232 2221 214A 242 262

251 $d_2$ 213A $d_1$ $l_{42}$ $l_{41}$ $l_{43}$

First direction

Fig. 19

First direction

Fig. 20

First direction

Fig. 21

Fig. 22

Fig. 23

First direction

Fig. 24

First direction

## INTERNATIONAL SEARCH REPORT

| | International application No. |
|---|---|
| | **PCT/CN2025/100738** |

**A. CLASSIFICATION OF SUBJECT MATTER**

H10F77/00(2025.01)i

According to International Patent Classification (IPC) or to both national classification and IPC

**B. FIELDS SEARCHED**

Minimum documentation searched (classification system followed by classification symbols)

IPC: H10F, H01L

Documentation searched other than minimum documentation to the extent that such documents are included in the fields searched

Electronic data base consulted during the international search (name of data base and, where practicable, search terms used)

CNABS, CNTXT, CNKI, VEN, ENTXT, IEEE: 背接触, 串联, 电池, 叠片, 叠瓦, 堆叠, 汇流带, 汇流条, 加宽, 绝缘, 扩展, 延伸, back, bus, busbar, contact, IBC, photovoltaic, solar, insulat+

**C. DOCUMENTS CONSIDERED TO BE RELEVANT**

| Category* | Citation of document, with indication, where appropriate, of the relevant passages | Relevant to claim No. |
|---|---|---|
| PX | CN 222786261 U (ZHUHAI FUSHAN AIKO SOLAR ENERGY TECHNOLOGY CO., LTD. et al.) 22 April 2025 (2025-04-22)<br>claims 1-10, description, paragraphs [0031]-[0082], and figures 1-6 | 1-9, 45 |
| PX | CN 119208422 A (ZHUHAI FUSHAN AIKO SOLAR ENERGY TECHNOLOGY CO., LTD. et al.) 27 December 2024 (2024-12-27)<br>claims 1-19, description, paragraphs [0067]-[0188], and figures 1-13 | 1-45 |
| PX | CN 119133288 A (ZHUHAI FUSHAN AIKO SOLAR ENERGY TECHNOLOGY CO., LTD. et al.) 13 December 2024 (2024-12-13)<br>claims 1-18, description, paragraphs [0083]-[0201], and figures 1-13 | 1-9, 28-45 |
| X | CN 118156332 A (ZHEJIANG AIKO SOLAR ENERGY TECHNOLOGY CO., LTD.) 07 June 2024 (2024-06-07)<br>description, paragraphs [0064]-[0144], and figures 1-18 | 1-9, 45 |
| A | CN 113611766 A (LONGI SOLAR TECHNOLOGY (TAIZHOU) CO., LTD.) 05 November 2021 (2021-11-05)<br>entire document | 1-45 |

☑ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **13 August 2025** | **28 August 2025** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2025/100738**

C.    DOCUMENTS CONSIDERED TO BE RELEVANT

| Category* | Citation of document, with indication, where appropriate, of the relevant passages | Relevant to claim No. |
|---|---|---|
| A | JP 2014075532 A (PANASONIC CORP.) 24 April 2014 (2014-04-24)<br>entire document | 1-45 |

## INTERNATIONAL SEARCH REPORT
### Information on patent family members

International application No.

**PCT/CN2025/100738**

| Patent document cited in search report | | | Publication date (day/month/year) | Patent family member(s) | | | Publication date (day/month/year) |
|---|---|---|---|---|---|---|---|
| CN | 222786261 | U | 22 April 2025 | None | | | |
| CN | 119208422 | A | 27 December 2024 | None | | | |
| CN | 119133288 | A | 13 December 2024 | None | | | |
| CN | 118156332 | A | 07 June 2024 | None | | | |
| CN | 113611766 | A | 05 November 2021 | CN | 113611766 | B | 21 March 2023 |
| JP | 2014075532 | A | 24 April 2014 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202421366666
- CN 202411273475
- CN 202411276522